# EUROPÄISCHE PATENTSCHRIFT

(11) **EP 3 271 979 B1**
(45) Veröffentlichungstag und Bekanntmachung des Hinweises auf die Patenterteilung: **06.05.2020**
(21) Anmeldenummer: 16709764.1
(22) Anmeldetag: 10.03.2016
(51) Int. Cl.: H02B 1/052, H02B 1/56, H05K 7/14, H05K 7/20

(54) **MODULARES SYSTEM**
MODULAR SYSTEM
SYSTÈME MODULAIRE

(30) Priorität: 18.03.2015 DE 102015104044
(43) Veröffentlichungstag der Anmeldung: 24.01.2018
(73) Patentinhaber: R. Stahl Schaltgeräte GmbH, 74638 Waldenburg (DE)
(72) Erfinder: FREY, Fritz, 74653 Künzelsau (DE); STÄHLE, Michael, 74613 Öhringen (DE)
(74) Vertreter: Rüger Abel Patentanwälte PartGmbB
(86) Internationale Anmeldenummer: PCT/EP2016/055186
(87) Internationale Veröffentlichungsnummer: WO 2016/146485

(56) Entgegenhaltungen:
- EP-A1- 1 524 890
- EP-A1- 2 512 210
- EP-A2- 1 137 334
- WO-A1-00/62376
- DE-A1- 3 632 470

## Beschreibung

Die Erfindung betrifft ein modular aufgebautes System mit wenigstens einem Modul. Das Modul weist einen Bauelementträger, beispielsweise eine Leiterplatte, und mehrere auf dem Bauelementträger angeordnete elektrische und/oder elektronische Bauelemente auf. Eines oder mehrere solcher Module werden durch einen Modulträger gehalten und können in einem Schaltschrank angeordnet werden.

Die elektrischen bzw. elektronischen Bauelemente können beim Betrieb warm werden und müssen ihre Wärme in die Umgebung abgeben. Es ist daher notwendig, die Bauelemente entsprechend zu kühlen. Abhängig von der elektrischen Leistung und der abgegebenen Wärme kann es daher notwendig sein, im Schaltschrank aktive Kühlungselemente wie Ventilatoren anzuordnen, um für eine ausreichende Luftzirkulation zu sorgen. Ferner muss die Warmluft aus dem Innenraum des Gehäuses nach außen abgegeben oder gekühlt werden.

Ein Modulträger für ein oder mehrere Module ist beispielsweise aus DE 10 2012 016 997 A1 bekannt. Die Leiterkarten sind dabei parallel zueinander und rechtwinklig zu einer Aufnahmefläche des Modulträgers gehalten. In der Aufnahmefläche sind Öffnungen vorhanden, die zum Einen als Sichtfenster und zum Anderen zur Luftzirkulation und zur Kühlung der Leiterkarten dienen, wobei die Luft zwischen zwei Leiterkarten durch die Aufnahmefläche strömen kann.

DE 10 2012 210 677 A1 beschreibt ein Leistungsmodul-Kühlsystem. Ein Modulträger hat eine Kühlplatte, an der von entgegengesetzten Seiten her zu kühlende Module angeordnet werden können. Die Kühlplatte hat auf den den Modulen zugewandten Montageseiten jeweils eine Durchbrechung, die von einer Dichtung umschlossen ist. Wenn die Module an der Kühlplatte angeordnet werden, ist der Spalt zwischen den Modulen und der Kühlplatte durch die Dichtung verschlossen. Die Kühlplatte ist hohl und weist an ihren Seitenflächen Lufteintritts- bzw. Luftaustrittsöffnungen auf. Durch diese Lufteintritts- bzw. Luftaustrittsöffnungen kann die Kühlplatte an ein Luftzirkulationssystem angeschlossen werden. Beim Betrieb werden die Module durch die Luft gekühlt, die im Inneren der Kühlplatte im Bereich der Durchbrechungen unmittelbar an den Modulen vorbei strömt und dabei eine Konvektionskühlung bewirkt.

Ein solches Kühlsystem ist sehr aufwendig und teuer. Es erfordert aktive Elemente zur Herstellung der Luftzirkulation innerhalb der Kühlplatte.

Aus EP 2 512 210 A1 ist ein modulares System nach dem Oberbegriff des Patentanspruches 1 bekannt.

DE 36 32 470 A1 beschreibt ein modulares System mit einem Schaltgerät und einem Geräteträger, die bei herstellen der mechanischen Verbindung einen Wärmeleitkontakt zwischen einer Anlagefläche des Schaltgeräts und einer Gegenanlagefläche des Geräteträgers herstellen. An einer zur Anlagefläche benachbarten Seite hat das Schaltgerät eine elektrische Kopplungseinrichtung zur Verbindung mit einer Anschlusseinrichtung des Geräteträgers.

Ausgehend vom Stand der Technik soll ein modulares System geschaffen werden, das eine einfache Kühlung der elektrischen und/oder elektronischen Bauelemente eines Moduls ermöglicht.

Diese Aufgabe wird durch ein modulares System mit den Merkmalen des Patentanspruches 1 gelöst.

Das modulare System weist wenigstens ein Modul auf. Zu dem Modul gehört ein Bauelementträger, beispielsweise eine Leiterplatte, auf der elektrische und/oder elektronische Bauelemente angeordnet sind. Außerdem hat das Modul einen Wärmeleitkörper, der thermisch mit den Bauelementen oder einem Teil der Bauelemente gekoppelt ist. Ein Modul kann auch mehrere Bauelementträger bzw. mehrere Leiterplatten aufweisen. Vorzugsweise hat der Wärmeleitkörper einen Plattenteil, der sich parallel zu dem Bauelementträger oder zwischen zwei Bauelementträgern erstreckt.

Das Modul hat eine mechanische Verbindungseinrichtung zur Verbindung mit einem Modulträger. An dem Wärmeleitkörper ist eine Anlagefläche vorhanden, die zur Herstellung einer Wärmeleitverbindung mit dem Modulträger dient. Die Anlagefläche erstreckt sich vorzugsweise in einer Ebene.

Das Modul hat bei einer bevorzugten Ausführungsform außerdem eine elektrische Kopplungseinrichtung, die elektrisch mit dem Bauelementträger und/oder wenigstens einem der Bauelemente verbunden ist. Die elektrische Kopplungseinrichtung kann beispielsweise mit einer oder mehreren Leiterbahnen bzw. Kontakten an dem Bauelementträger verbunden sein.

Der wenigstens eine Modulträger des modularen Systems weist eine Halteeinrichtung zur Herstellung einer mechanischen Verbindung mit der jeweils zugeordneten Verbindungseinrichtung eines Moduls auf.

Optional ist an jedem Modulträger eine Anschlusseinrichtung vorhanden, die dazu eingerichtet ist, eine elektrische Verbindung mit der Kopplungseinrichtung eines zugeordneten Moduls herzustellen. Dadurch lassen sich z.B. mehrere an dem Modulträger angeordnete Module elektrisch miteinander koppeln.

An dem Modulträger ist eine sich vorzugsweise in einer Ebene erstreckende Gegenanlagefläche vorhanden. Die Anlagefläche und die Gegenanlagefläche liegen aneinander an, wenn zwischen der Halteeinrichtung des Modulträgers und der Verbindungseinrichtung des Moduls eine Verbindung hergestellt ist. Die Anlagefläche und die Gegenanlagefläche sind vorzugsweise komplementär zueinander ausgeführt.

Erfindungsgemäß wird die Wärme durch Wärmeleitung abgeführt, so dass Einrichtungen zur Erzeugung einer Kühlmediumströmung durch oder auf die Module oder zwischen zwei Modulen hindurch nicht erforderlich sind. Die an den Bauelementen entstehende Wärme wird über den Wärmeleitkörper und von dort durch den flächigen Wärmeleitkontakt zwischen der Anlagefläche und der Gegenanlagefläche in den Modulträger abgeleitet werden. Es hat sich gezeigt, dass durch eine solche Ausgestaltung auf eine erzwungene Luft- bzw. Gaszirkulation mit Hilfe von Ventilatoren zwischen den Bauelementträgern bzw. Leiterplatten verzichtet werden kann. Mittel, die die Luft gezielt zu den Modulen bzw. Leiterplatten leiten, sind nicht notwendig und können entfallen. Dies hat insbesondere den Vorteil, dass die Bauelementträger bzw. Leiterplatten in beliebiger Ausrichtung in einem Schaltschrank oder Gehäuse angeordnet werden können. Bislang wurden die Leiterplatten in der Regel vertikal ausgerichtet, um die Luftzirkulation im Schaltschrank zwischen den Leiterplatten zu ermöglichen.

Es ist bevorzugt, wenn der Wärmeleitkörper einen Plattenteil aufweist, der sich quer zu der Anlagefläche erstreckt. Dabei kann auf jeder Seite des Plattenteils ein Bauelementträger eines Moduls angeordnet sein. Vorzugsweise befinden sich die Bauelemente, die gekühlt werden müssen, auf derselben Seite des Bauelementträgers und sind dem Plattenteil zugewandt. Insbesondere steht die dem Bauelementträger abgewandte Oberseite jedes zu kühlenden Bauteils in Kontakt mit dem Plattenteil. Zwischen dieser Oberseite des Bauelements und dem Plattenteil kann eine Wärmeleitschicht, eine Wärmeleitfolie oder dergleichen vorhanden sein. Es ist auch möglich, die Bauelementträger mit den Bauelementen und dem Plattenteil durch Eingießen zu verbinden. Dies kann beispielsweise bei der Anwendung des modularen Systems in einer explosionsgeschützten Atmosphäre der Zone 1 erforderlich sein.

Durch die Anlage der zu kühlenden Bauelemente an den Plattenteil mit oder ohne Zwischenschaltung einer Wärme leitenden Schicht ist ein guter, flächiger Wärmeleitkontakt zwischen dem Wärmeleitkörper und den zu kühlenden Bauelementen realisiert.

Der Plattenteil kann auf einer oder beiden Seiten, die den zu kühlenden Bauelementen zugewandt ist bzw. sind, Erhöhungen und/oder Vertiefungen aufweisen, um unterschiedliche Bauhöhen der Bauelemente auszugleichen. Die Mittelebene durch das Plattenteil und die Mittelebene durch den Bauelementträger können bei dieser Ausführung einen konstanten Abstand zueinander aufweisen, der beispielsweise durch Abstandshalter vorgegeben sein kann. Die unterschiedlichen Bauhöhen der Bauelemente werden durch Erhöhungen bzw. Vertiefungen am Plattenteil ausgeglichen, so dass alle zu kühlenden Bauteile einen ausreichend guten Wärmeleitkontakt zum Plattenteil aufweisen. Alternativ zu dieser Ausgestaltung ist es auch möglich, sämtliche Oberseiten von den zu kühlenden Bauelementen in einer gemeinsamen Ebene anzuordnen, beispielsweise in dem elektrische und/oder elektronische Bauelemente mit geringerer Bauhöhe auf Sockeln auf dem Bauelementträger montiert werden.

Bei einem bevorzugten Ausführungsbeispiel des Systems ist der Wärmeleitkörper als integraler Körper ausgeführt und weist keine Naht- oder Fügestelle auf. Beispielsweise kann der Wärmeleitkörper als Aluminium-Druckgussteil ausgeführt sein. Vorzugsweise hat der Wärmeleitkörper in seinem Inneren keine Kammern oder Hohlräume zur Fluidleitung.

Es ist weiter vorteilhaft, wenn die Halteeinrichtung einen Halteteil aufweist, der eine Schwenkachse definiert. Dabei kann die Verbindungseinrichtung einen Verbindungsteil aufweisen, der dazu eingerichtet ist, an dem Halteteil anzugreifen und eine Schwenkbewegung des Moduls um die Schwenkachse zu ermöglichen. Der Verbindungsteil kann den Halteteil in Umfangsrichtung um die Schwenkachse zumindest abschnittsweise umgreifen. Die Schwenkbewegung kann dazu dienen, die elektrische Kopplungseinrichtung des Moduls mit der elektrischen Anschlusseinrichtung des Modulträgers zu verbinden und insbesondere ineinander zu stecken.

Vorzugsweise ist die Schwenkachse parallel zu der Gegenkontaktfläche ausgerichtet. Insbesondere hat die Schwenkachse einen Abstand zu der Gegenkontaktfläche in einer Höhenrichtung, die rechtwinklig zur Schwenkachse und zur Gegenkontaktfläche orientiert ist.

Die Richtung, in die sich die Schwenkachse erstreckt, kann als Längsrichtung bezeichnet werden. Die Richtung rechtwinklig zur Höherichtung und rechtwinklig zur Längsrichtung kann als Querrichtung bezeichnet werden.

Vorzugsweise ist an dem Verbindungsteil eine Aufnahmeaussparung vorhanden, die dazu eingerichtet ist, den Halteteil, zumindest teilweise, aufzunehmen. Die Aufnahmeaussparung kann hierzu in der Längsrichtung parallel zu der Schwenkachse offen sein. Der Halteteil kann sich somit entlang der Schwenkachse vollständig durch die Aufnahmeaussparung erstrecken. Vorzugsweise ist die Aufnahmeaussparung zur Einführung des Halteteils zu einer Seite hin offen.

Die Halteeinrichtung des Modulträgers hat bei einem bevorzugten Ausführungsbeispiel mit Abstand zum Halteteil einen Anbringungsteil. Die Verbindungseinrichtung des Moduls kann mit Abstand zum Verbindungsteil einen Befestigungsteil aufweisen. Der Befestigungsteil und der Anbringungsteil sind vorzugsweise dazu eingerichtet, kraftschlüssig und/oder formschlüssig miteinander verbunden und insbesondere lösbar verbunden zu werden. Beispielsweise kann der Anbringungsteil mit dem Befestigungsteil über einen Gewindebolzen oder dergleichen verbunden werden. Anstelle oder zusätzlich zu einer Gewindeverbindung sind auch Rast und/oder Klemmverbindungen zwischen dem Anbringungsteil und dem Befestigungsteil herstellbar.

Es ist weiter bevorzugt, wenn die Anschlusseinrichtung zwischen dem Halteteil und dem Anbringungsteil angeordnet ist. Entsprechend kann die Kopplungseinrichtung zwischen dem Verbindungsteil und dem Befestigungsteil angeordnet sein. Bei dieser Ausführung ist eine sichere elektrische Kontaktierung zwischen dem Modulträger und dem Modul erreicht.

Der Wärmeleitkörper hat bei einem Ausführungsbeispiel zwischen dem Verbindungsteil und dem Befestigungsteil einen plattenförmigen Basisteil, der als Wärmeleitbrücke dient. Der Basisteil ist insbesondere rechtwinklig zum Plattenteil ausgerichtet. Durch diese Wärmeleitbrücke ist ein Temperaturausgleich im Kühlkörper zwischen dem Verbindungsteil und dem Befestigungsteil erreicht.

Die Verbindungseinrichtung kann eine Positionierfläche aufweisen, die mit Abstand zum Verbindungsteil angeordnet ist und die dem Verbindungsteil abgewandt ist. Die Halteeinrichtung kann eine Positioniergegenfläche aufweisen, die mit Abstand zum Halteteil angeordnet ist und die dem Halteteil zugewandt ist. Bei hergestellter Verbindung zwischen der Verbindungseinrichtung und der Halteeinrichtung liegt die Positionierfläche an der Positioniergegenfläche an. Dadurch kann die Relativlage des Moduls gegenüber dem Modulträger in einer Richtung rechtwinklig zur Schwenkachse und vorzugsweise in Querrichtung definiert werden.

Insbesondere wird bei der Herstellung der Verbindung ein Kontakt zwischen der Positionierfläche und der Positioniergegenfläche erreicht, bevor die Kopplungseinrichtung und die Anschlusseinrichtung eine elektrische Verbindung herstellen können. Dadurch ist sichergestellt, dass beim Herstellen einer Steckverbindung die zu verbindenden Kontakte korrekt zugeordnet werden und keine versehentlichen Kurzschlüsse entstehen.

Vorzugsweise ist die Positioniergegenfläche geneigt zur Gegenanlagefläche und die Positionierfläche geneigt zur Anlagefläche ausgerichtet. Die Positioniergegenfläche kann in einer Ebene angeordnet sein, die parallel zur Schwenkachse bzw. zur Längsrichtung verläuft.

Bei einer bevorzugten Ausführungsform weist die Halteeinrichtung und/oder die Verbindungseinrichtung eine Krafterzeugungseinrichtung auf. Die Krafterzeugungseinrichtung erzeugt bei hergestellter Verbindung zwischen der Halteeinrichtung und der Verbindungseinrichtung eine Andrücckraft zwischen der Anlagefläche und der Gegenanlagefläche. Zusätzlich dazu kann die Krafterzeugungseinrichtung auch eine Andrückkraft zwischen der Positionierfläche und der Positioniergegenfläche erzeugen, wenn zwischen der Halteeinrichtung und der Verbindungseinrichtung eine Verbindung hergestellt ist.

Bei einem Ausführungsbeispiel weist die Krafterzeugungseinrichtung ein elastisches oder federelastisches Krafterzeugungselement auf, das sich bei hergestellter Verbindung zwischen der Halteeinrichtung und der Verbindungseinrichtung einerseits am Halteteil und andererseits am Verbindungsteil abstützt. Das Krafterzeugungselement kann beispielsweise am Verbindungsteil angeordnet oder angebracht sein und mit einem Abschnitt in die Aufnahmeaussparung hineinragen. Mit diesem Abschnitt kann sich das Krafterzeugungselement bei hergestellter Verbindung am Halteteil abstützen.

Bei einem Ausführungsbeispiel ist das Krafterzeugungselement als federelastisches Drahtbiegeteil ausgeführt.

Es ist außerdem vorteilhaft, wenn der Modulträger als Integralkörper ohne Naht- und Fügestelle ausgeführt ist. Beispielsweise kann der Modulträger durch ein Strangpressprofil gebildet sein. Der Modulkörper besteht vorzugsweise aus Aluminium.

Es kann vorteilhaft sein, wenn in dem Modulträger wenigstens ein Kühlkanal vorhanden ist. Der Kühlkanal kann beispielsweise benachbart zur Gegenanlagefläche angeordnet sein und parallel dazu und vorzugsweise parallel zur Schwenkachse verlaufen. Der Kühlkanal kann eine in Umfangsrichtung vollständig geschlossene Kanalwand aufweisen, die nicht unterteilt und mithin nicht geschlitzt ist.

Es ist bevorzugt, wenn der wenigstens eine Kühlkanal eine unrunde Kontur und vorzugsweise eine elliptische Kontur aufweist. Die Kanalhöhe in Höhenrichtung ist dabei vorteilhafterweise kleiner als die Kanalbreite in Querrichtung.

In einen Abschnitt des unrund und vorzugsweise elliptisch konturierten Kühlkanals kann ein Wärmerohr bzw. eine Heatpipe eingesteckt sein. Die Heatpipe hat in einem unverformten Ausgangszustand einen Außendurchmesser, der größer ist als die Kanalhöhe und kleiner als die Kanalbreite. Der in dem Kühlkanal eingesteckte Teil der Heatpipe verformt sich und liegt zumindest an zwei diametral gegenüberliegenden Stellen im Bereich der geringeren Kanalhöhe an der Kanalwand an. Eine Presspassung ist vorzugsweise vermieden und in Richtung der Kanalbreite ist ein Zwischenraum zwischen der Heatpipe und der Kanalwand vorhanden. Auf diese Weise kann eine Heatpipe kraftschlüssig im Kühlkanal ohne Herstellung einer Presspassung gehalten werden. Die Montage ist dabei sehr einfach und dennoch wird ein sehr guter Wärmeübergang von der Kanalwand in die Heatpipe sichergestellt.

Der Modulträger weist insbesondere auf seiner der Gegenanlagefläche entgegengesetzten Seite wenigstens eine Montagefläche auf, mit der er in montiertem Zustand an einer Gehäusewand oder Montageplatte im Innenraum eines Gehäuses anliegt. Dadurch ist eine Wärme leitende Verbindung zu der Gehäusewand oder der Montageplatte hergestellt. Vorzugsweise ist der wenigstens eine Kühlkanal zwischen der wenigstens einen Montagefläche und der Gegenanlagefläche angeordnet.

Insbesondere ist das modulare System dazu vorgesehen, in einem Gehäuseinnenraum eines Gehäuses angeordnet zu werden. Vorzugsweise ist der Gehäuseinnenraum hermetisch gegen die Umgebung abgedichtet. Das Gehäuse kann explosionsgeschützt ausgeführt sein, beispielsweise in der Zündschutzart "druckfeste Kapselung". Der Modulträger ist dabei an einer Gehäusewand bzw. einer Montageplatte im Gehäuseinnenraum angeordnet. Vorzugsweise sind in dem Gehäuseinnenraum keine aktiven Bauteile wie Pumpen oder Gebläse zur Erzeugung eines Kühlfluidstroms vorhanden. Die Gehäuseinnenwand bzw. die Montageplatte kann dazu verwendet werden, im Gehäuseinnenraum eine Konvektionsströmung zu erzeugen.

Vorteilhafte Ausgestaltungen der Erfindung ergeben sich aus den abhängigen Patentansprüchen, der Beschreibung und der Zeichnung. Nachfolgend werden bevorzugte Ausführungsbeispiele der Erfindung anhand der beigefügten Zeichnung im Einzelnen erläutert. Es zeigen:
Figur 1 ein Ausführungsbeispiel eines modularen Systems mit einem Modulträger und einem Modul in einer perspektivischen Darstellung während der Herstellung der Verbindung,
Figur 2 das modulare System aus Figur 1 in einer Seitenansicht während der Herstellung der Verbindung,
Figur 3 das modulare System gemäß der Figuren 1 und 2 bei vollständig hergestellter Verbindung zwischen dem Modul und dem Modulträger in einer Seitenansicht,
Figur 4 ein Ausführungsbeispiel eines Wärmeleitkörpers eines Moduls in einer perspektivischen Ansicht,
Figur 5 den Wärmeleitkörper aus Figur 4 in einer Vorderansicht auf einen Verbindungsteil,
Figur 6 eine perspektivische Teildarstellung eines Moduls mit Blick auf die elektrische Kopplungseinrichtung und einen Basisteil des Wärmeleitkörpers aus den Figuren 4 und 5,
Figur 7 eine schematische Teildarstellung eines Plattenteils des Wärmeleitkörpers aus den Figuren 4 bis 6 sowie eines elektrische und/oder elektronische Bauelemente aufweisenden Bauelementträgers,
Figur 8 eine Teildarstellung des Modulträgers und des Moduls in einer Seitenansicht während der Herstellung der Verbindung,
Figur 9 eine schematische perspektivische Darstellung eines Krafterzeugungselements des Ausführungsbeispiels des modularen Systems bzw. des Wärmeleitkörpers gemäß der Figuren 1 bis 7,
Figur 10 eine Prinzipdarstellung der Form eines Kühlkanals im Modulträger sowie der Verformung einer Heatpipe beim Einstecken in den Kühlkanal,
Figur 11 eine schematische Prinzipdarstellung eines Gehäuses mit mehreren im Gehäuseinnenraum angeordneten modularen Systemen und
Figur 12 eine Prinzipdarstellung des Gehäuses in einer Schnittdarstellung gemäß der Schnittlinie XII-XII in Figur 11.

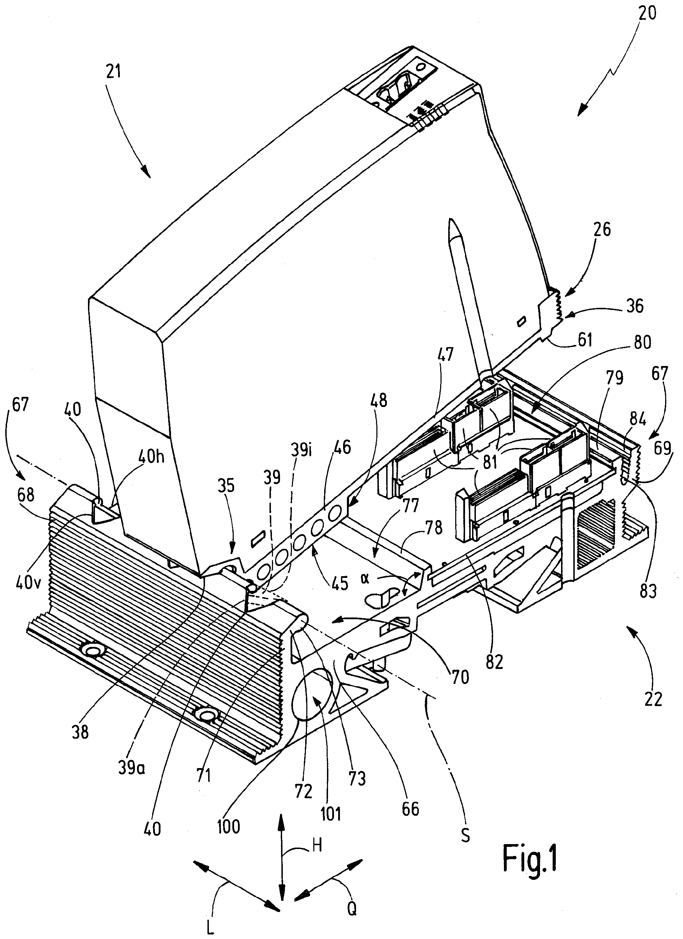

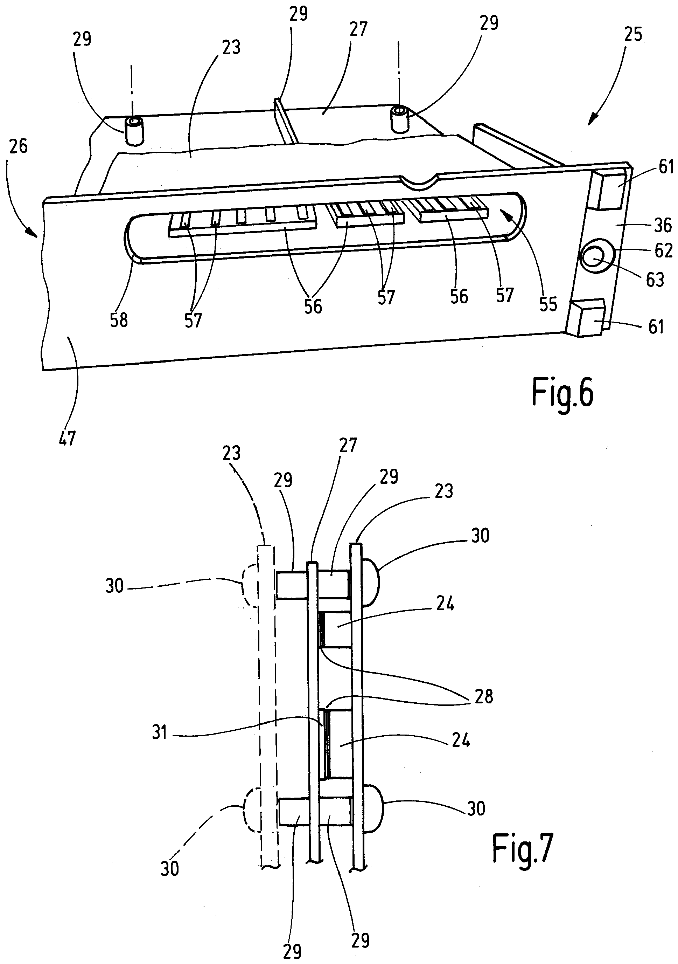

In den Figuren 1 bis 3 ist ein Ausführungsbeispiel eines modularen Systems 20 veranschaulicht. Zu dem modularen System 20 gehören wenigstens ein Modul 21 sowie ein Modulträger 22, der zum mechanischen Halten und elektrischen Verbinden des wenigstens einen Moduls 21 dient. Das Modul 21 weist wenigstens einen Bauelementträger 23 auf, an dem elektrische und/oder elektronische Bauelemente 24 angeordnet sind. Der Bauelementträger 23 und die Bauelemente 24 sind in den Figur 6 bzw. 7 veranschaulicht. Der Bauelementträger 23 kann als Leiterplatte ausgeführt sein. Auf dem Bauelementträger 23 können Leiterbahnen zur Kontaktierung der Bauelemente 24 vorhanden sein.

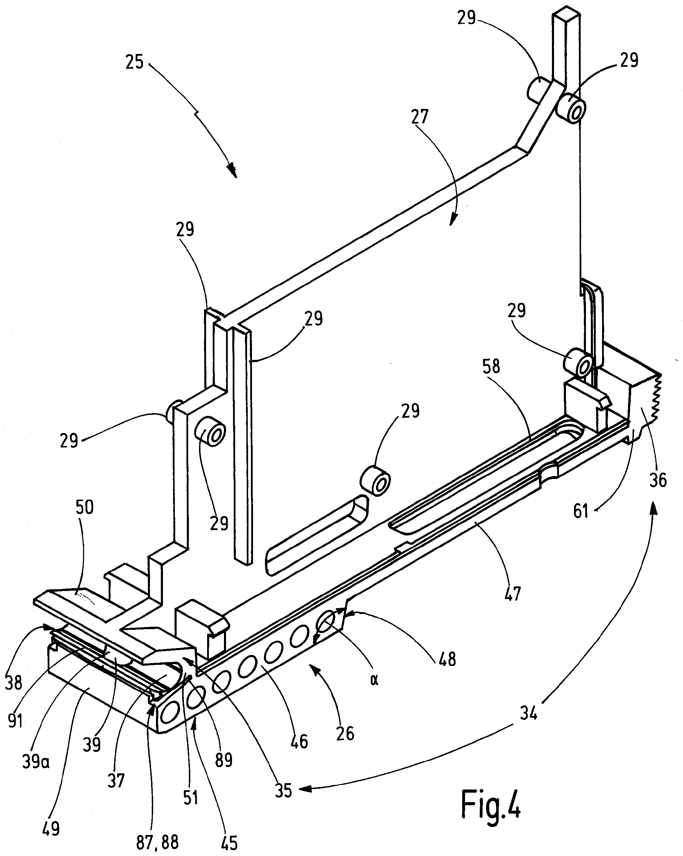

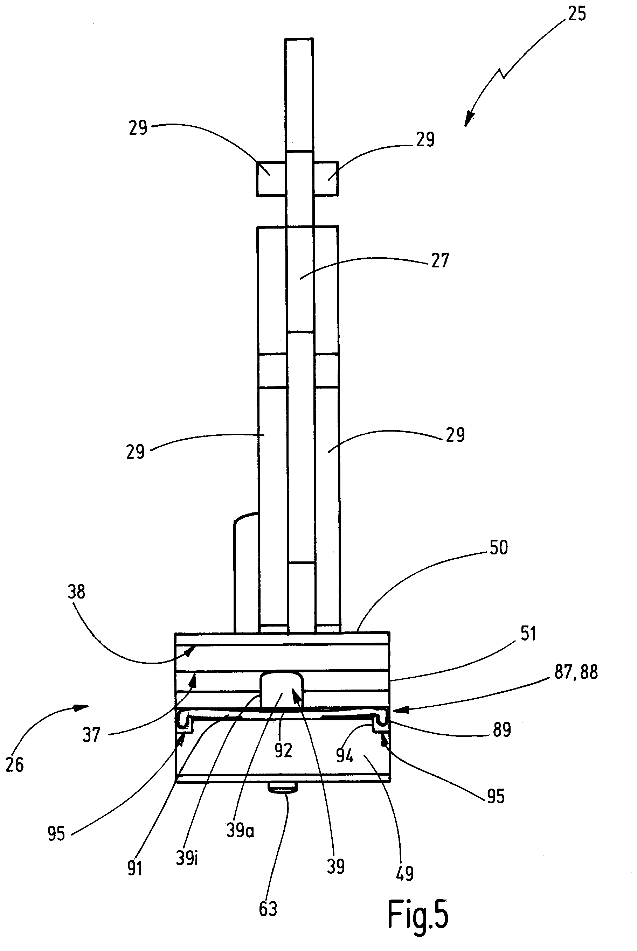

Zu jedem Modul 21 gehört ein Wärmeleitkörper 25, der separat in den Figuren 4 und 5 dargestellt ist. Der Wärmeleitkörper 25 hat einen Basisteil 26 und einen Plattenteil 27. Der Plattenteil 27 ist an einer Seite mit dem Basisteil 26 verbunden und ragt vom Basisteil 26 weg. Der Plattenteil 27 ist dazu eingerichtet, eine wärmeleitende Verbindung zwischen dem Wärmeleitkörper 25 und den Bauelementen 24 herzustellen, die gekühlt werden müssen. Diese Wärmeleitverbindung ist schematisch in Figur 7 veranschaulicht. Die zu kühlenden Bauelemente 24 sind auf der Seite des Bauelementträgers 23 angeordnet, der dem Plattenteil 27 zugewandt ist. Mit ihrer dem Plattenteil 27 zugewandten Oberseite liegen die Bauelemente 24 an dem Plattenteil 27 an. Optional kann zwischen der Oberseite der zu kühlenden Bauelemente 24 und dem Plattenteil 27 eine Wärmeleitschicht 28, beispielsweise ein Wärmeleitpad oder eine Wärmeleitfolie angeordnet sein.

An dem Plattenteil 27 sind Abstandshalteelemente 29 angeordnet. Die Abstandshalteelemente 29 geben den Abstand zwischen dem Bauelementträger 23 und dem Plattenteil 27 vor. Dieser Abstand ist an die Bauhöhe der zu kühlenden Bauelemente 24 angepasst. Ein Abstandshalteelement 29 kann grundsätzlich eine beliebige Gestalt aufweisen. Beispielhaft sind hier ein stegförmiges Abstandhalteelement 29 sowie zylindrische bzw. hohlzylindrische Abstandshalteelemente 29 veranschaulicht. Die hohlzylindrischen Abstandshalteelemente 29 können mit einem Innengewinde ausgeführt sein, so dass diese Abstandshalteelemente 29 auch zum Befestigen des Bauelementträgers 23 an dem Wärmeleitkörper 25 bzw. dem Plattenteil 27 dienen können. In Figur 7 ist schematisch veranschaulicht, dass der Bauelementträger 23 an mehreren Stellen mit Schrauben 30 an den als Innengewindebuchsen ausgeführten Abstandshalteelemente 29 befestigt ist. Mit Hilfe dieser Schraubverbindung ist sichergestellt, dass die zu kühlenden Bauelemente 24 mit ihrer Oberseite einen flächigen Wärmeleitkontakt zum Plattenteil 27 mit einer ausreichend großen Andrückkraft aufweisen. Wenn die optionale Wärmeleitschicht 28 vorgesehen ist, können auch kleinere Unebenheiten in dem Plattenteil 27 durch elastische Verformung der Wärmeleitschicht 28 ausgeglichen werden.

In Figur 7 ist außerdem eine weitere optionale Möglichkeit dargestellt, um unterschiedliche Bauhöhen der zu kühlenden Bauelemente 24 rechtwinklig zur Erstreckungsebene des Bauelementträgers 23 auszugleichen. Der Plattenteil 27 kann beispielsweise wenigstens eine Erhöhung 31 aufweisen, um einen solchen Bauhöhenunterschied auszugleichen. Alternativ hierzu könnten auch Vertiefungen im Plattenteil 27 vorgesehen sein, wobei solche Vertiefungen nur dann verwendet werden können, wenn die Dicke des Plattenteils 27 ausreichend groß ist, um den Plattenteil 27 nicht zu sehr zu schwächen. Eine weitere Möglichkeit zum Ausgleichen der Bauhöhenunterschiede besteht darin, die Bauelemente 24 auf dem Bauelementträger 23 mit Hilfe von Sockeln oder dergleichen anzubringen, so dass die Oberseiten der zu kühlenden Bauelemente 24 in einer gemeinsamen Ebene liegen.

Ein Modul 21 kann mehrere Bauelementträger 23 bzw. Leiterplatten aufweisen, die von entgegengesetzten Seiten an dem Plattenteil 27 angebracht sind (Figur 7). Wie erläutert, sind die zu kühlenden Bauelemente 24 dabei stets auf der Seite angeordnet, die dem Plattenteil 27 zugewandt ist. Auf der jeweils anderen Seite des Bauelementträgers 23 können auch Bauelemente 24 sein, wenn diese keiner oder einer geringeren Kühlung bedürfen.

Der wenigstens eine Bauelementträger 23 mit den Bauelementen 24 kann mit dem Plattenteil 27 auch in einen gemeinsamen Vergusskörper integriert werden. Das Vergussmaterial wird dabei so gewählt, dass ein ausreichend geringer Wärmeleitwiderstand sichergestellt und eine gute Wärmeleitung zwischen den Bauelementen 24 und dem Plattenteil 27 besteht. Dieser Verguss kann insbesondere dann vorgesehen werden, wenn das modulare System 20 z.B. in einem explosionsgeschützten Gehäuse zur Verwendung in einem explosionsgefährdeten Bereich vorgesehen ist.

An dem Wärmeleitkörper 25 und beispielsgemäß am Basisteil 26 ist eine Verbindungseinrichtung 34 vorhanden, die zur mechanischen Verbindung des Moduls 21 mit dem Modulträger 22 eingerichtet ist. Die Verbindungseinrichtung 34 hat einen Verbindungsteil 35 und einen Befestigungsteil 36. Der Verbindungsteil 35 und der Befestigungsteil 36 sind in Erstreckungsrichtung des Basisteils 26 des Wärmeleitkörpers 25 mit Abstand zueinander angeordnet und befinden sich beispielsgemäß an entgegengesetzten Enden des Basisteils 26.

Der Verbindungsteil 35 weist eine Aufnahmeaussparung 37 auf. Die Aufnahmeaussparung 37 ist zu der Seite, die vom Basisteil 26 bzw. vom Befestigungsteil 36 weg weist durch eine Einführöffnung 38 vollständig geöffnet. Durch die Einführöffnung 38 kann ein Bestandteil des Modulträgers 22 in die Aufnahmeaussparung 37 eingeführt werden. In einer Richtung, die beispielsgemäß rechtwinklig zu dem Plattenteil 27 orientiert ist, durchsetzt die Aufnahmeaussparung 37 den Wärmeleitkörper 25 bzw. dessen Basisteil 26 vollständig. Ein in die Aufnahmeaussparung 37 eingeführtes Teil kann daher quer zum Plattenteil 27 an beiden Seiten aus der Aufnahmeaussparung 37 herausragen.

Innerhalb der Aufnahmeaussparung 37 ist ein Positioniervorsprung 39 vorhanden. Der Positioniervorsprung 39 erweitert sich beim Ausführungsbeispiel von einem äußeren Ende 39a zu einem inneren Ende 39i hin und kann eine in etwa dreieckförmige Kontur aufweisen. Der Positioniervorsprung 39 ist in Figur 1 gestrichelt in einer Lage veranschaulicht, in der er mit einer Positionieraussparung 40 am Modulträger 22 zusammenwirkt.

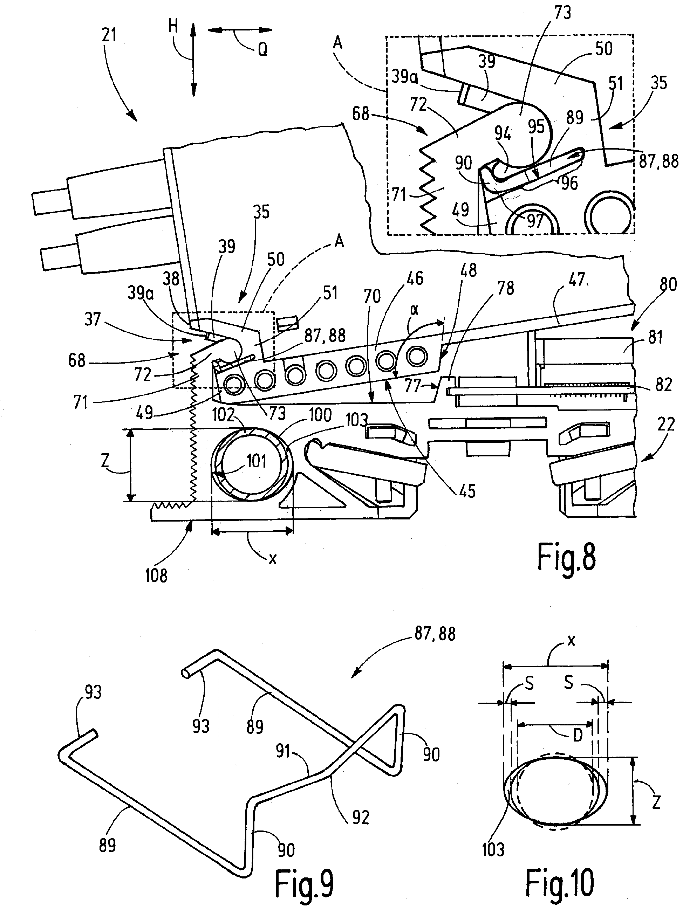

An dem Basisteil 26 ist auf der dem Modulträger 22 zugewandten bzw. zugeordneten Unterseite eine Anlagefläche 45 vorhanden. Die Anlage 45 erstreckt sich beim Ausführungsbeispiel in einer Ebene, die rechtwinklig zu der Erstreckungsebene des Plattenteils 27 ausgerichtet ist. Die Anlagefläche 45 ist an einem vorderen Abschnitt 46 des Basisteils 26 angeordnet. An diesen vorderen Abschnitt 46 schließt sich ein hinterer Abschnitt 47 an, der an seinem Ende den Befestigungsteil 36 aufweist. Die Dicke des vorderen Abschnitts 46 rechtwinkelig zu den Anlagefläche ist größer als die des sich anschließenden hinteren Abschnitts 47, so dass im Übergangsbereich zwischen den beiden Abschnitten 46, 47 ein Absatz mit einer Positionierfläche 48 gebildet ist. Die Positionierfläche 48 erstreckt sich in einer Ebene, die mit der Ebene, in der sich die Anlagefläche 45 erstreckt, einen stumpfen Winkel α einschließt (Figuren 4 und 8). Der stumpfe Winkel α ist bevorzugt größer als 100° und liegt vorzugsweise im Bereich zwischen 100° und 110°.

Unterhalb der Aufnahmeaussparung 37 bildet der vordere Abschnitt 46 einen Basisteilvorsprung 49, der zum Verbindungsteil 35 gehört. Auf der den Basisteilvorsprung 49 entgegengesetzten Seite der Aufnahmeaussparung 37 hat der Verbindungsteil 35 einen Verbindungsvorsprung 50, der über ein Zwischenstück 51 mit dem vorderen Abschnitt 46 des Basisteils 26 verbunden ist. Der Positioniervorsprung 39 ist am Verbindungsvorsprung 50 und/oder am Zwischenstück 51 angeordnet. Das Zwischenstück 51 erstreckt sich in etwa rechtwinkelig vom vorderen Abschnitt weg.

Das Modul 21 weist außerdem eine elektrische Kopplungseinrichtung 55 auf, die schematisch in Figur 6 veranschaulicht ist. Zu der Kopplungseinrichtung 55 gehört beim Ausführungsbeispiel wenigstens ein Steckkontakt 56, der im vorliegenden Fall durch Randbereiche des Bauelementträgers 23 gebildet ist, wobei an diesen Randbereichen Kontaktpads 57 in Form von Leiterbahnenden zur elektrischen Kontaktierung vorhanden sind. In Abwandlung zu dem in Figur 8 veranschaulichten Ausführungsbeispiel könnte die Kopplungseinrichtung 55 auch Steckbuchsen und/oder anders ausgeführte Stecker aufweisen. Beispielsgemäß ist die Kopplungseinrichtung 55 ausschließlich mit Steckkontakten 56 in Form von Steckern zur Aufnahme in einer zugeordneten Steckkontaktbuchse ausgeführt.

Um die Kopplungseinrichtung 55 bzw. die Steckkontakte 56 zugänglich zu machen ist in dem Basisteil 26 und beispielsgemäß dem hinteren Abschnitt 47 eine Durchbrechung 58 vorhanden. Die Durchbrechung 58 ist beim Ausführungsbeispiel als Langloch ausgeführt, parallel oder entlang dessen Mittelebene sich die Steckkontakte 56 der Kopplungseinrichtung 55 erstrecken. In Abwandlung zu dem dargestellten Ausführungsbeispiel kann das Modul 21 auch mehrere Gruppen von Steckkontakten 56 aufweisen, die jeweils wenigstens einem Bauelementträger 23 zugeordnet sind. Entsprechend könnten auch mehrere Durchbrechungen 58 im Basisteil 26 vorhanden sein, um die mehreren Gruppen von Steckkontakten 56 zugänglich zu machen, vorzugsweise mindestens eine Durchbrechung 58 im Basisteil 26 auf jeder Seite des Plattenteils 27.

Auf der dem Plattenteil 27 abgewandten Unterseite weist der Befestigungsteil 36 wenigstens ein und beispielsgemäß zwei oder mehr Erhebungen 61 auf. Die Erhebungen 61 sind beim Ausführungsbeispiel in einer Richtung rechtwinklig zur Erstreckungsrichtung des Plattenteils 27 mit Abstand zueinander entlang einer Linie angeordnet. Beispielsgemäß verjüngen sich die Erhebungen 61 vom Basisteil 26 weg. Im Querschnitt sind die Erhebungen 61 rechteckförmig.

An dem Befestigungsteil 36 ist außerdem ein Durchgangsloch 62 vorhanden, durch das eine Befestigungsschraube 63 hindurchgreifen kann. Die Befestigungsschraube 63 dient zur form- bzw. kraftschlüssigen Befestigung des Befestigungsteils 36 am Modulträger 22. Das Befestigungsloch 62 ist vorzugsweise zwischen den Erhebungen 61 angeordnet.

Der Wärmeleitkörper 25 ist beim Ausführungsbeispiel als integrales Bauteil ausgeführt und besteht vorzugsweise aus Aluminium bzw. einer Aluminiumlegierung. Er weist keine Naht- oder Fügestelle auf. Er ist frei von zur Führung eines Kühlungsfluids vorgesehenen Fluidkanälen. Der Wärmeleitkörper 25 kann zwar Aussparungen, Löcher oder Durchbrechungen aufweisen, die jedoch nicht zur Fluidleitung eines Kühlungsfluids vorgesehen sind, sondern dazu dienen können, das Gewicht des Wärmeleitkörpers 25 und mithin den Materialbedarf bei seiner Herstellung zur reduzieren. Vorzugsweise ist der Wärmeleitkörper 25 als Aluminiumdruckgusskörper ausgeführt.

Der Modulträger 22 weist einen Modulkörper 66 auf, der vorzugsweise aus Aluminium oder einer Aluminiumlegierung besteht. Der Modulkörper 66 ist ohne Naht- und Fügestelle integral ausgeführt und beispielsweise durch einen Strangpressprofilkörper gebildet.

Für die nachfolgende Beschreibung wird ein Koordinatensystem eingeführt, das ortsfest gegenüber dem Modulkörper 66 ist. Das Koordinatensystem hat eine Höhenrichtung H, rechtwinklig dazu eine Querrichtung Q und rechtwinklig zur Höhenrichtung H und zur Querrichtung Q eine Längsrichtung L.

Der Modulkörper 66 weist eine Halteeinrichtung 67 auf, die zur Herstellung der mechanischen Verbindung mit dem wenigstens einen Modul 21 eingerichtet ist und hierfür mit der Verbindungseinrichtung 34 zusammenwirkt. Die Halteeinrichtung 67 ist beispielsgemäß integraler Bestandteil des Modulkörpers 66. Zu der Halteeinrichtung 67 des Modulträgers 22 gehört ein Halteteil 68 sowie ein Anbringungsteil 69. Der Halteteil 68 und der Anbringungsteil 69 sind in Querrichtung Q mit Abstand zueinander angeordnet. Beispielsgemäß befinden sich der Halteteil 68 und der Anbringungsteil 69 an entgegengesetzten Endbereichen des Modulkörpers 66.

Der Modulkörper 66 weist eine Gegenanlagefläche 70 auf, die sich in einer Ebene erstreckt. Bei hergestellter Verbindung zwischen dem Modul 21 und dem Modulträger 22 liegt die Anlagefläche 45 des Wärmeleitkörpers 25 an der Gegenanlagefläche 70 des Modulträgers 22 an. Die Gegenkontaktfläche 70 erstreckt sich in einer Ebene, die durch die Querrichtung Q und die Längsrichtung L aufgespannt wird. Am einen, vorderen Ende weist der Modulkörper 66 benachbart zur Gegenanlagefläche 70 einen Steg 71 auf, der benachbart zur Gegenanlagefläche 70 angeordnet ist und sich in Höhenrichtung H erstreckt.

In Höhenrichtung H mit Abstand zur Gegenanlagefläche 70 ragt von dem Steg 71 ein Quersteg 72 weg, der zumindest eine Erstreckungskomponente in Querrichtung Q aufweist. Beim Ausführungsbeispiel verläuft der Quersteg 72 ausgehend vom Steg 71 schräg in Querrichtung Q und gleichzeitig in Höhenrichtung H geneigt. An dem freien Ende ist am Quersteg 72 ein verdicktes Endstück 73 ausgebildet. Das Endstück 73 bildet eine Schwenkachse S. Hierzu weist es zumindest eine Außenflächenbereich auf, der sich auf einer Zylindermantelfläche um die Schwenkachse S befindet. Dieser gekrümmte Außenflächenbereich des Endstücks 73 ist in Umfangsrichtung um die Schwenkachse S nicht vollständig geschlossen, sondern endet jeweils an der Übergangsstelle zum Quersteg 72. Die Schwenkachse S erstreckt sich in Längsrichtung L.

In dem Endstück 73 bzw. dem Quersteg 72 ist zur Positionierung wenigstens eines Moduls 21 in Längsrichtung L für jedes am Modulträger 22 anbringbare Modul 21 die Positionieraussparung 40 vorhanden (Figur 1). Die Positionieraussparung 40 bildet eine Vertiefung, die sich im Quersteg 72 und/oder im Endstück 73 durch den Halteteil 68 erstreckt. Die Positionieraussparung 40 ist nach oben, von der Gegenanlagefläche 70 weg sowie in Querrichtung Q auf der dem Steg 71 abgewandten Seite des Endstücks 73 offen. Die Positionieraussparung 40 erweitert sich ausgehend von einem vorderen Ende 40v zu einem hinteren Ende 40h hin. Beispielsweise hat die Positionieraussparung 40 eine in etwa dreieckförmige Kontur. Beispielsgemäß befindet sich das vordere Ende 40v im Quersteg 72, während das hintere Ende 40h im Endstück 73 angeordnet ist.

Mit Abstand zu dem Halteteil 68 bzw. dem Steg 71 weist der Modulkörper 66 eine Positioniergegenfläche 77 auf. Die Positioniergegenfläche 77 grenzt beispielsgemäß an die Gegenanlagefläche 70 an. Die Positioniergegenfläche 77 hat eine Erstreckungskomponente in Längsrichtung L. Gegenüber der Höhenrichtung H und der Querrichtung Q verläuft die Positioniergegenfläche 77 geneigt. Ihr Normalenvektor weist zum Halteteil 68 hin, beispielsgemäß zum Steg 71 bzw. zum Endstück 73. Der Winkel, den die Positioniergegenfläche 77 mit der Gegenanlagefläche 70 einschließt, entspricht dem stumpfen Winkel α (Figur 1).

Die Positioniergegenfläche 77 ist beim Ausführungsbeispiel an einem ersten Längssteg 78 angeordnet. Der erste Längssteg 78 erstreckt sich in Längsrichtung L und ragt von der Ebene, in der sich die Gegenanlagefläche 70 erstreckt, in Höhenrichtung H weg.

Ein zweiter Längssteg 79, der sich parallel zum ersten Längssteg 78 in Längsrichtung L erstreckt, gehört zu dem Anbringungsteil 69. Zwischen den beiden Längsstegen 78, 79 ist eine elektrische Anschlusseinrichtung 80 des Modulträgers 22 angeordnet. Die elektrische Anschlusseinrichtung 80 ist dazu eingerichtet, bei hergestellter mechanischer Verbindung zwischen der Verbindungseinrichtung 34 und der Halteeinrichtung 67 eine elektrische Verbindung mit der Kopplungseinrichtung 55 des Moduls 21 herzustellen.

Beim Ausführungsbeispiel weist die Anschlusseinrichtung 80 entsprechend komplementär zu den elektrischen Kontakten der Kopplungseinrichtung 55 ausgebildete elektrische Gegenkontakte auf. Beispielsgemäß ist jedem Steckkontakt 56 der Kopplungseinrichtung 55 eines Moduls 21 eine entsprechende Steckkontaktbuchse 81 zugeordnet (Figur 1, 2 und 8). Die Steckkontaktbuchsen 81 sind an einer Anschlussplatte angeordnet 82, die beispielsgemäß als Leiterplatte ausgeführt sein kann. Die Anschlussplatte 82 ist zwischen den beiden Längsstegen 78, 79 gehalten. Hierfür sind in die Längsstege 78, 79 entsprechende Nuten eingebracht, in die die Längskanten der Anschlussplatte 82 eingreifen.

Auf der Anschlussplatte 82 können elektrische Verbindungen, wie etwa Leiterbahnen, vorhanden sein. Dadurch können elektrische Anschlüsse der Steckkontaktbuchsen 81 miteinander elektrisch verbunden werden. Die Anschlussplatte 82 kann - sofern erforderlich - auch zusätzliche elektrische und/oder elektronische Bauelemente tragen. Somit kann über die Anschlusseinrichtung 80 eine elektrische Verbindung zwischen mehreren Modulen 21 hergestellt werden, die an dem Modulträger 22 angeordnet sind. Beispielsweise kann die Anschlusseinrichtung 80 eine Busverbindung für die Module 21 zur Verfügung stellen.

Benachbart zum zweiten Längssteg 79 ist in dem Anbringungsteil 69 eine in Höhenrichtung H nach oben offene Längsnut 83 eingebracht. Die Längsnut 83 weist an den sich gegenüberliegenden Nutflanken jeweils eine geriffelte Oberfläche auf. Diese Riffelungen sind dazu eingerichtet, mit dem Außengewinde der Befestigungsschraube 63 des Moduls 21 zusammen zu arbeiten, so dass das Außengewinde der Befestigungsschraube 63 formschlüssig und/oder kraftschlüssig in die Riffelung der Nutflanken eingreifen kann, um eine Verbindung herzustellen.

Die Längsnut 83 hat an der Oberseite im Anschluss an die Längskanten zwischen den sich gegenüberliegenden Nutflanken einen Mündungsabschnitt 84. Der Mündungsabschnitt 84 verjüngt sich in Höhenrichtung H von der Oberseite in die Längsnut 83 hinein. Seine Querschnittskontur ist an die Querschnittskontur der Erhebungen 61 angepasst. Die beiden in Querrichtung Q entgegengesetzten Seitenflächen jeder Erhebung 61 liegen bei hergestellter Verbindung zwischen dem Modul 21 und dem Modulträger 22 an den Nutflanken der Längsnut 83 im Mündungsabschnitt 84 an. Im Mündungsabschnitt 84 sind die Nutflanken nicht geriffelt und erstrecken sich jeweils in einer Ebene.

Das modulare System 20 weist außerdem eine Krafterzeugungseinrichtung 87 auf. Die Krafterzeugungseinrichtung 87 ist dazu eingerichtet, bei hergestellter mechanischer Verbindung zwischen der Verbindungseinrichtung 34 und der Halteeinrichtung 67 eine Andrückkraft zwischen der Anlagefläche 45 und der Gegenanlagefläche 70 und beim Ausführungsbeispiel außerdem eine Andrückkraft zwischen der Positionierfläche 48 und der Positioniergegenfläche 77 zu erzeugen. Hierfür weist die Krafterzeugungseinrichtung 87 ein Krafterzeugungselement 88 auf und ist beispielsgemäß durch ein Krafterzeugungselement 88 gebildet. Das Krafterzeugungselement 88 hat elastische bzw. federelastische Eigenschaften und wird beim Herstellen der Verbindung eines Moduls 21 mit dem Modulträger 22 elastisch verformt bzw. verspannt. Die Verformung bzw. Verspannung erzeugt eine Kraft, die zumindest in Höhenrichtung H und beispielsgemäß außerdem in Querrichtung Q wirkt.

Das Krafterzeugungselement 88 ist beispielsgemäß als Drahtbiegeteil ausgeführt (Figur 9). Es weist zwei parallel zueinander verlaufende erste Schenkel 89 auf. An die ersten Schenkel 89 schließt sich jeweils ein zweiter Schenkel 90 an, der im Wesentlichen rechtwinklig zum zugeordneten ersten Schenkel 89 verläuft. Die beiden zweiten Schenkel 90 sind über ein Zwischenstück 91 miteinander verbunden, da es den Abstand zwischen den beiden zweiten Schenkeln 90 in Längsrichtung L bzw. in einer Richtung rechtwinklig zur Erstreckungsebene des Plattenteils 27 überbrückt. Das Zwischenstück 91 kann geradlinig und damit rechtwinklig zu den ersten Schenkeln 89 und den zweiten Schenkeln 90 verlaufen. Beispielsgemäß ist das Zwischenstück 91 an einer Stelle und vorzugsweise mittig zwischen den beiden zweiten Schenkeln 90 abgewinkelt und hat einen V-förmigen Verlauf. An seiner abgewinkelten Stelle 92 hat das Zwischenstück 91 den geringsten Höhenabstand zu der Ebene, in der sich die beiden ersten Schenkel 89 erstrecken. An den den zweiten Schenkeln 90 entgegengesetzten Enden der ersten Schenkel 89 ist jeweils ein Endabschnitt 93 vorhanden. Die beiden Endabschnitte 93 erstrecken sich zu ihrem jeweiligen freien Ende aufeinander zu und sind beispielsgemäß auf einer gemeinsamen Geraden angeordnet.

Das Krafterzeugungselement 88 ist beim Ausführungsbeispiel am Verbindungsteil 35 angeordnet. Die beiden ersten Schenkel 89 erstrecken sich auf entgegengesetzten Seiten des Verbindungsteils 35 in jeweils einer Stützaussparung 94. Die Stützaussparung 94 hat eine unterhalb des jeweiligen ersten Schenkels 89 angeordnete Stützfläche 95 (siehe insbesondere Detail A in Figur 8). Die Stützfläche 95 verläuft nicht vollständig parallel zum ersten Schenkel 89, sondern stützt den ersten Schenkel 89 im Anschluss an den Endabschnitt 93 in einem Stützbereich 96 ab. Außerhalb des Stützbereichs 96 hat die Stützfläche 95 im unverformten Ausgangszustand des Krafterzeugungselements 88 einen Abstand zum ersten Schenkel 89, so dass dort ein Freiraum 97 gebildet ist. Dieser Freiraum 97 erlaubt eine elastischen Verformung des Krafterzeugungselements 88 und insbesondere ein Biegen des jeweiligen ersten Schenkels 89.

Durch die V-Form des Zwischenstücks 91 kann sich auch das Zwischenstück 91 elastisch verformen. Die abgewinkelte Stelle 92 liegt hierzu am Verbindungsteil 35 an, während sich die Übergangsbereiche zwischen den zweiten Schenkeln 90 und dem Zwischenstück 91 bei hergestellter Verbindung des Moduls 21 mit dem Modulträger 22 am Halteteil 68 abstützen können. Zumindest das Zwischenstück 91 ragt in unverformtem Zustand des Krafterzeugungselements 88 teilweise aus der Stützaussparung 94 heraus und kann in die Aufnahmeaussparung 37 zumindest teilweise hineinragen.

Die Verbindung zwischen einem Modul 21 und dem Modulträger 22 wird wie folgt hergestellt:
Das Modul 21 wird mit dem Verbindungsteil 35 auf den Halteteil 68 aufgesteckt, so dass das Endstück 73 durch die Einführöffnung 38 in die Aufnahmeaussparung 37 gelangt und dort am Verbindungsteil 35 anliegt. Dabei greift der Positioniervorsprung 39 in die zugeordnete Positionieraussparung 40 ein. Dies sorgt dafür, dass das Modul 21 in Längsrichtung des Modulträgers 22 exakt positioniert wird. Die sich erweiternde Positionieraussparung 40 bzw. der sich erweiternde Positioniervorsprung 39 erleichtern das Aufstecken des Verbindungsteils 35 auf den Halteteil 68.

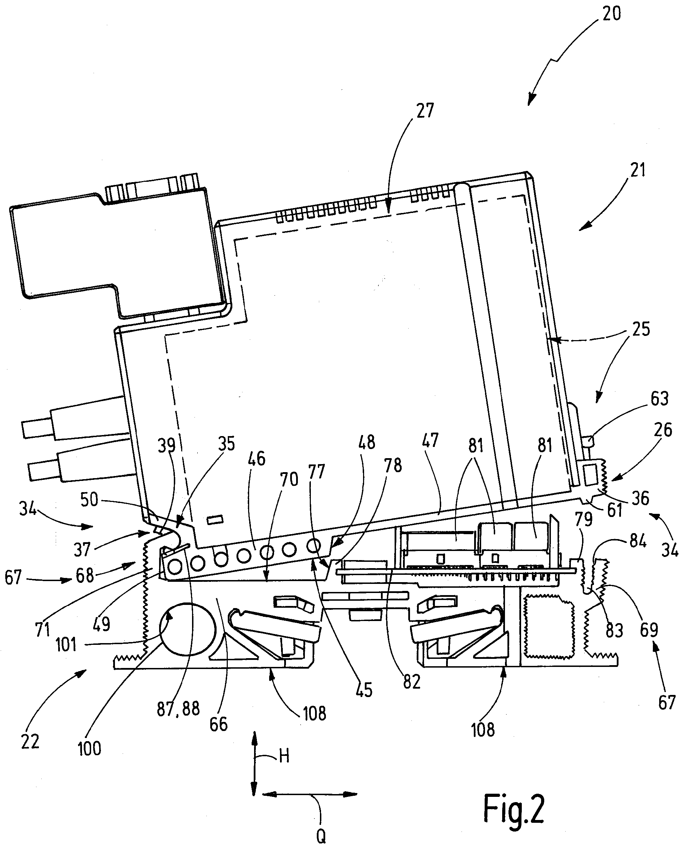

Diese aufgesteckte Stellung ist in den Figur 1 und 2 veranschaulicht. Der Basisteil 26 des Wärmeleitkörpers 25 erstreckt sich dabei ausgehend vom Halteteil 68 schräg geneigt zur Höhenrichtung H weg. Die Kopplungseinrichtung 55 ist in dieser Position noch mit Abstand zur Anschlusseinrichtung 80 angeordnet, so dass noch keine elektrische Verbindung zwischen dem Modul 21 und dem Modulträger 22 besteht. Ebenso besteht ein Abstand zwischen dem Befestigungsteil 36 und dem Anbringungsteil 69.

Das Modul 20 kann jetzt um die Schwenkachse S geschwenkt werden. Das Krafterzeugungselement 88 stützt sich dabei zwischen dem Halteteil 68 und dem Verbindungsteil 35 ab und wird elastisch verformt. Der Basisteilvorsprung 49 ist zwischen der Ebene, in der sich die Gegenanlagefläche 70 erstreckt und dem Halteteil 68 bzw. dem Endstück 73 angeordnet und wird durch die Verspannung des Krafterzeugungselementes 88 in Höhenrichtung H nach unten zum Modulkörper 66 hin gedrängt.

Der Wärmeleitkörper 25 und der Modulkörper 66 sind derart dimensioniert, dass während der Schwenkbewegung die Positionierfläche 48 in Kontakt mit der Positioniergegenfläche 77 gelangt, bevor eine elektrische Verbindung zwischen der Kopplungseinrichtung 55 und der Anschlusseinrichtung 80 hergestellt wird. Dadurch wird erreicht, dass die elektrischen Kontakte der Kopplungseinrichtung 55 relativ zu den elektrischen Kontakten der Anschlusseinrichtung 80 in Querrichtung Q des Modulträgers 20 exakt positioniert werden. Somit lassen sich Kurzschlüsse oder ungewollte elektrische Verbindungen vermeiden.

Aufgrund der Neigung der Positioniergegenfläche 77 bzw. der Neigung der Positionierfläche 48 bzw. der Positioniergegenfläche wird der Wärmeleitkörper 25 zu dem Halteteil 68 hin gedrängt. Dort stützt sich das Krafterzeugungselement 88 am Halteteil 68 ab. Dies kann beispielsgemäß dadurch erfolgen, dass das Krafterzeugungselement 88 nach vorne über den Basisteilvorsprung 49 etwas hinaus ragt und sich am Quersteg 72 und/oder am Steg 71 des Halteteils 68 abstützt. Dadurch kann das Krafterzeugungselement 88 eine Andrückkraft zwischen der Positionierfläche 48 und der Positioniergegenfläche 77 erzeugen. Demzufolge wird in Querrichtung Q eine exakte Relativpositionierung des Moduls 21 gegenüber dem Modulträger 22 erreicht.

Nachdem die Positionierfläche 48 und die Positioniergegenfläche 77 in Kontakt gelangt sind, wird bei einer fortgesetzten Schwenkbewegung die elektrische Verbindung zwischen der Kopplungseinrichtung 55 und der Anschlusseinrichtung 80 hergestellt. Beispielsgemäß werden die Stecckontakte 56 in die Steckkontaktbuchsen 81 eingeführt.

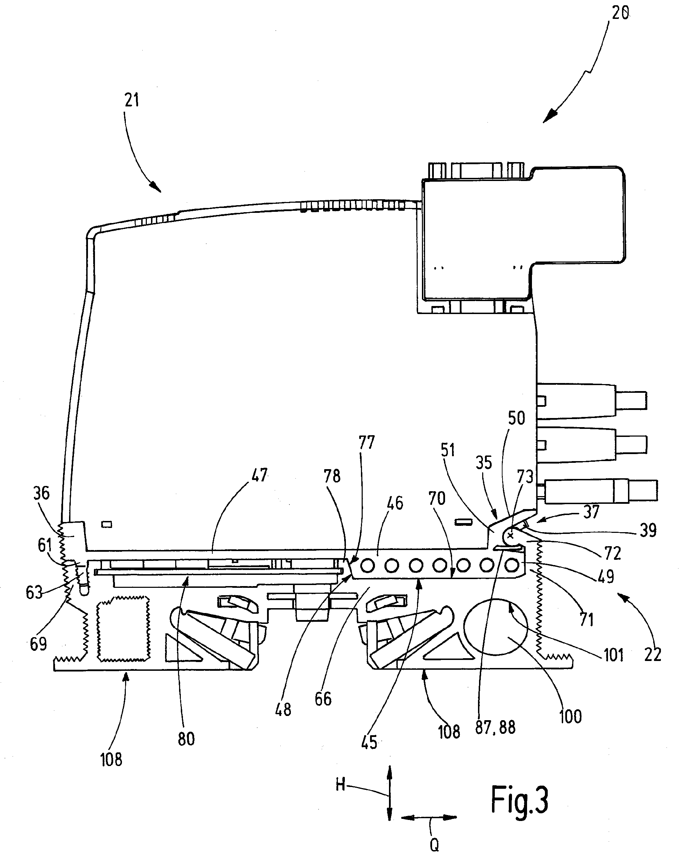

Wenn die Schwenkbewegung vollständig ausgeführt ist, liegt die Anlagefläche 45 an der Gegenanlagefläche 70 an (Figur 3). Das Krafterzeugungselement 88 erzeugt in Höhenrichtung H eine Andrückkraft zwischen der Anlagefläche 45 und der Gegenanlagefläche 70. An dem entgegengesetzten Ende wird eine kraftschlüssige und/oder formschlüssige Verbindung zwischen dem Halteteil 68 und dem Anbringungsteil 69 hergestellt. Ein Formschluss, zumindest in Querrichtung Q, ist dadurch erreicht, dass die Erhebungen 61 im Mündungsabschnitt 84 an den Nutflanken der Längsnut 83 anliegen. Über die Befestigungsschraube 63 wird der Halteteil 68 am Anbringungsteil 69 gesichert. Dabei wird wiederum eine Andrückkraft zwischen dem Wärmeleitkörper 26 und dem Modulkörper 66 im Bereich des Halteteils 68 und des Anbringungsteils 69 hergestellt.

Die vollständig hergestellte Verbindung ist in Figur 3 in Seitenansicht veranschaulicht. Ein besonders guter Wärmeleitkontakt ist zwischen der Anlagefläche 45 und der Gegenanlagefläche 70 hergestellt. Ein weiterer guter Wärmeleitkontakt ist am in Querrichtung Q anderen Ende im Bereich des Befestigungsteils 36 und des Anbringungsteils 69 erreicht. Durch die Wärmeleitung kann die Wärme von den Bauelementen 24 über den Plattenteil 27 und den Basisteil 26 in den Modulkörper 66 geleitet werden. Diese Wärmeleitung stellt eine effiziente Kühlung der Bauelemente 24 bereit. Die mechanische und elektrische Verbindung zwischen dem Modul 21 und dem Modulträger 22 lässt sich sehr einfach herstellen und wieder lösen.

Das Lösen der Verbindung erfolgt in umgekehrter Reihenfolge entsprechend dem Herstellen der Verbindung. Auf die vorstehende Erläuterung kann daher verwiesen werden.

In dem Modulkörper 66 kann wenigstens ein Kühlkanal 100 vorhanden sein. Der Kühlkanal 100 weist eine Kanalwand 101 auf. Die Kanalwand 101 ist in Umfangsrichtung vollständig geschlossen und an keiner Stelle in zwei relativ zueinander bewegbare Abschnitte unterteilt. Beim Ausführungsbeispiel verläuft der Kühlkanal 100 in Längsrichtung L im Modulkörper 100 benachbart zur Gegenanlagefläche 70.

Der Querschnitt des Kühlkanals 100 ist unrund ausgeführt und hat beispielsgemäß eine elliptische Gestalt. Der Kühlkanal 100 weist eine Kanalhöhe z auf, deren Betrag kleiner ist als die Kanalbreite x jeweils an der Stelle mit maximaler Abmessung gemessen (Figur 8). Die Kanalhöhe z und die Kanalbreite x sind beispielsgemäß entlang der Halbachsen der elliptischen Kontur des Kühlkanals 100 gemessen. Die kleinere Halbachse der Ellipse erstreckt sich beispielsgemäß in Höhenrichtung H und die größere Halbachse der Ellipse in Querrichtung Q.

In den Kühlkanal 100 kann ein Abschnitt einer Heatpipe 102 eingesteckt werden, die in Figur 5 im Querschnitt schematisch veranschaulicht ist. In unverformtem Zustand weist die Heatpipe 102 einen Außendurchmesser D auf (Figur 10). Der Außendurchmesser D der Heatpipe ist größer als die Kanalhöhe z und kleiner als die Kanalbreite x. Beim Eindrücken der Heatpipe 102 verformt sich der in den Kühlkanal 100 eingepresste bzw. eingesteckte Abschnitt und erhält ebenfalls eine in etwa elliptische Kontur. Die Kanalbreite x des Kühlkanals 100 ist so groß gewählt, dass keine Presspassung zwischen der Heatpipe 102 und dem Kühlkanal 100 entsteht. Vielmehr liegt die Heatpipe 102 an den sich in Kanalhöhe z gegenüberliegenden Bereichen der Kanalwand 101 an. In Richtung der Kanalbreite x verbleibt ein Zwischenraum 103 zwischen der Außenfläche der Heatpipe 102 und der Kanalwand 101, der an der breitesten Stelle den Abstand s aufweist. Diese Situation ist in Figur 10 stark schematisiert veranschaulicht. Es versteht sich, dass die Darstellung nach Figur 6 nicht maßstabsgetreu ist sondern lediglich der Veranschaulichung des Prinzips dient.

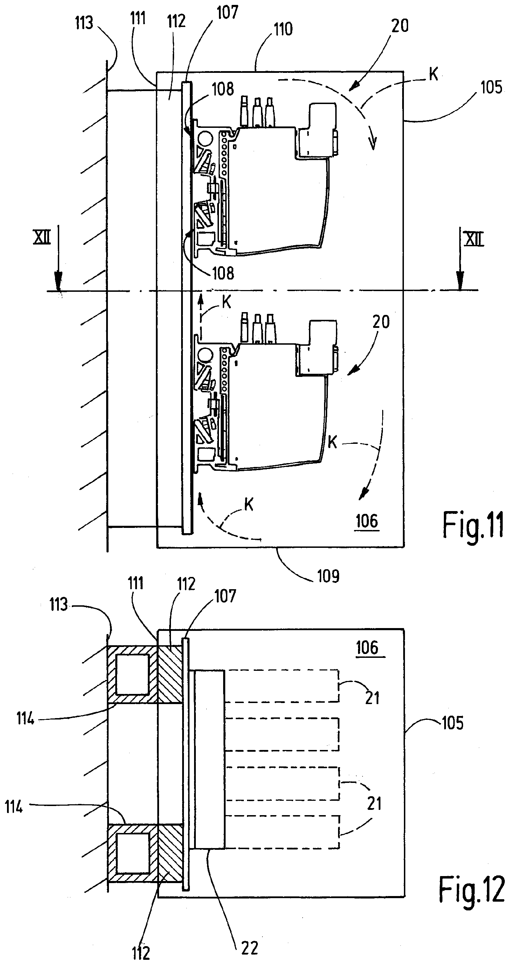

Das modulare System 20 eignet sich zur Anbringung in einem Gehäuse und beispielsweise in einem explosionsgeschützten Gehäuse 105, das stark schematisiert in Figuren 11 und 12 veranschaulicht ist. Das explosionsgeschützte Gehäuse 105 umschließt einen Gehäuseinnenraum 106 insbesondere hermetisch bzw. gasdicht. Das explosionsgeschützte Gehäuse 105 kann beispielsweise in der Zündschutzart "druckfeste Kapselung" ausgeführt sein. In dieser Ausführung kann ein Gasaustausch zwischen dem Gehäuseinnenraum 106 und der explosionsgefährdeten Atmosphäre in der Umgebung nicht stattfinden. Es muss daher für eine ausreichende Kühlung gesorgt werden, ohne die Anforderungen an den Explosionsschutz zu verletzen.

Im Innenraum des explosionsgeschützten Gehäuses 105 ist eine Montageplatte 107 angeordnet, die sich beispielsweise in Vertikalrichtung erstreckt. Die Modulträger 22 weisen jeweils eine oder mehrere Montageflächen 108 auf, mit denen sie an der Montageplatte 107 anbringbar sind. Die Montageflächen 108 sind am Modulkörper 66 vorhanden und erstrecken sich in einer gemeinsamen Ebene. Die wenigstens eine Montagefläche 108 weist von der Gegenanlagefläche 70 weg und ist vorzugsweise parallel dazu ausgerichtet. Vorzugsweise ist zumindest eine Montagefläche vorhanden, die benachbart zur Gegenanlagefläche 70 angeordnet ist. Der wenigstens eine Kühlkanal 100 kann vorzugsweise zwischen einer Montagefläche 108 und der Gegenanlagefläche 70 angeordnet sein.

Zwischen der wenigstens einen Montagefläche 108 und der Montageplatte 107 kann eine Wärme leitende Schicht angeordnet werden, beispielsweise um Unebenheiten auszugleichen und einen guten Wärme leitenden Kontakt sicherzustellen.

Die Montageplatte 107 erstreckt sich in Vertikalrichtung möglichst durch das gesamte Gehäuse vom Gehäuseboden 109 bis zur Gehäusedecke 110. Die Höhe der Montageplatte 107 entspricht vorzugsweise mindestens 70% oder 80% oder 90% des Abstands zwischen dem Gehäuseboden 109 und der Gehäusedecke 110.

Die Montageplatte 107 kann unmittelbar an einer Gehäusewand, beispielsweise der Gehäuserückwand 111 angebracht sein. Dies ist zur Vereinfachung der Montage allerdings häufig nicht sinnvoll oder nicht möglich. Um dennoch einen guten wärmeleitenden Kontakt zwischen der Montageplatte 107 und der entsprechenden Gehäusewand, beispielsgemäß der Gehäuserückwand 111, sicherzustellen, sind beispielsgemäß sich in Vertikalrichtung erstreckende Montageplattenhalter 112 vorhanden, die als Wärme leitende Elemente und sozusagen als Wärmebrücke dienen. Dadurch kann die vom Modulträger 22 bzw. dem Modulkörper 66 in die Montageplatte 107 eingeleitete Wärme über die Montageplattenhalter 112 in die Gehäuserückwand 111 geleitet werden.

Das explosionsgeschützte Gehäuse 105 ist beispielsgemäß dazu eingerichtet, an einer Wand 113 montiert zu werden. Beispielsweise befindet sich die Wand 113 auf einer Bohrinsel oder an Bord eines Schiffes, insbesondere auf Deck. Zur Befestigung des Gehäuses 105 an der Wand 113 sind Montagestreben 114 vorgesehen. Die Montagestreben 114 sind beim Ausführungsbeispiel durch Rohre und beispielsgemäß Rechteckrohre gebildet. Sie sind an ihren beiden Enden in Vertikalrichtung offen. Durch die vertikale Ausrichtung ist eine Luftzirkulation durch die rohrförmigen Montagestreben 114 möglich. Die Montagestreben 114 sind an der Stelle an der Außenseite des Gehäuses 105 angebracht, an der sich innen die Montageplattenhalter 112 befinden. Dadurch wird eine verbesserte Wärmeleitverbindung vom Montageplattenhalter 112 durch die Gehäusewand bzw. die Gehäuserückwand 111 in die Montagestrebe 114 erreicht.

Bei dem hier beschriebenen explosionsgeschützten Gehäuse 105 wird im Gehäuseinnenraum 106 eine Konvektionsströmung K der Luft oder des im Gehäuse 105 befindlichen Gases erreicht. Wenn sich die elektrischen und/oder elektronischen Bauelemente 24 der Module 21 erwärmen, wird die Wärme über den Wärmeleitkörper 25 in den Modulkörper 66 und von diesem in die Montageplatte 107 geleitet. Die Montageplatte 107 ist aus gut Wärme leitendem Material, beispielsweise Aluminium. Sie erwärmt sich beim Betrieb der elektrischen und/oder elektronischen Bauelemente sehr gleichmäßig. Dadurch, dass sie im Gehäuseinnenraum 106 eine große Fläche einnimmt und sich möglichst vollständig in Vertikalrichtung durch den Gehäuseinnenraum 106 erstreckt, wird ohne aktive Kühlelemente und insbesondere ohne Gebläse eine Zirkulation durch Konvektion und mithin die Konvektionsströmung K in Gang gesetzt. Die Luft wird erwärmt und steigt in der Nähe der Montageplatte auf. Im Bereich der Gehäusedecke 110 wird sie von der Montageplatte 107 weg gedrängt und kann sich abkühlen und sinkt entsprechend ab. Die Montageplatte 107 und die Montageplattenhalter 112 führen durch Wärmeleitung ausreichend Wärme aus dem Gehäuseinnenraum 106 nach außen ab. In den rohrförmigen Montagestreben 114 kann sich außerhalb des Gehäuses 105 ebenfalls eine Konvektionsströmung ausbilden.

Es hat sich gezeigt, dass bei dieser Ausgestaltung des Gehäuses eine Temperaturdifferenz von wenigen Grad Celsius, insbesondere weniger als 5°C und bei einem Ausführungsbeispiel etwa 3°C einstellt. Bei vergleichbaren Gehäusen ohne die Verwendung der Montageplatte und die Wärmeabfuhr durch Wärmeleitung haben sich Temperaturdifferenzen in Vertikalrichtung von etwa 15°C eingestellt. Durch die Verwendung der Montageplatte sind die im unteren Bereich des Gehäuses 105 angeordneten elektrischen und/oder elektronischen Komponenten besser vor Überhitzung geschützt.

Die Montageplatte weist eine Dicke von wenigstens 2 mm oder 3 mm auf. Durch die Verbindung der Montageplatte über die Montageplattenhalter 112 und die Montagestreben 114 wird eine insgesamt stabile Anordnung erreicht, die wenig empfindlich ist gegen Vibrationen. Bei dieser Anordnung kommt es auf die Eigenstabilität des Gehäuses 105 nicht an. Die Haltekräfte werden hauptsächlich durch die Montagestreben 114, die Montageplattenhalter 112 und die Montageplatte 107 aufgebracht.

Die Erfindung betrifft ein modulares System 20 sowie ein für die Aufnahme eines solchen modularen Systems 20 geeignetes explosionsgeschütztes Gehäuse 105. Das modulare System 20 weist wenigstens ein Modul 21 mit elektrischen und/oder elektronischen Bauelementen 24 auf. Das wenigstens eine Modul 21 kann an einem Modulträger 22 angeordnet werden. Jedes Modul 21 enthält einen und insbesondere einen einzigen Wärmeleitkörper 25. Der Wärmeleitkörper 25 weist ein Basisteil 26 und ein quer vom Basisteil 26 weg ragendes Plattenteil 27 auf. Die zu kühlenden Bauelemente 24 liegen unter Herstellung einer Wärmeleitverbindung an dem Plattenteil 27 an. Am Basisteil 26 ist eine Anlagefläche 45 ausgebildet, die dem Modulträger 22 zugeordnet ist. Bei hergestellter mechanischer Verbindung zwischen dem Modul 21 und dem Modulträger 22 liegt die Anlagefläche 45 an einer zugeordneten Gegenanlagefläche 70 des Modulträgers 22 an. Durch Wärmeleitung kann die Wärme der Bauelemente 24 über den Wärmeleitkörper 25 in den Modulträger 22 abgeleitet werden.

### Bezugszeichenliste:

- 20: modulares System
- 21: Modul
- 22: Modulträger
- 23: Bauelementträger
- 24: Bauelement
- 25: Wärmeleitkörper
- 26: Basisteil
- 27: Plattenteil
- 28: Wärmeleitschicht
- 29: Abstands
- 30: Erhöhung
- 31: Schraube

- 34: Verbindungseinrichtung
- 35: Verbindungsteil
- 36: Befestigungsteil
- 37: Aufnahmeaussparung
- 38: Einführöffnung
- 39: Positioniervorsprung
- 39a: äußeres Ende des Positioniervorsprungs
- 39i: inneres Ende des Positioniervorsprungs
- 40: Positionieraussparung
- 40v: vorderes Ende der Positionieraussparung
- 40h: hinteres Ende der Positionieraussparung

- 45: Anlagefläche
- 46: vorderer Abschnitt des Basisteils
- 47: hinterer Abschnitt des Basisteils
- 48: Positionierfläche
- 49: Basisteilvorsprung
- 50: Verbindungsvorsprung
- 51: Zwischenstück

- 55: Kopplungseinrichtung
- 56: Steckkontakt
- 57: Kontaktpad
- 58: Durchbrechung

- 61: Erhebung
- 62: Durchgangsloch
- 63: Befestigungsschraube

- 66: Modulköper
- 67: Halteeinrichtung
- 68: Halteteil
- 69: Anbringungsteil
- 70: Gegenanlagefläche
- 71: Steg
- 72: Quersteg
- 73: Endstück

- 77: Positioniergegenfläche
- 78: erster Längssteg
- 79: zweiter Längssteg
- 80: Anschlusseinrichtung
- 81: Steckkontaktbuchsen
- 82: Anschlussplatte
- 83: Längsnut
- 84: Mündungsabschnitt

- 87: Krafterzeugungseinrichtung
- 88: Krafterzeugungselement
- 89: erster Schenkel
- 90: zweiter Schenkel
- 91: Zwischenstück
- 92: abgewinkelte Stelle
- 93: Endabschnitt
- 94: Stützaussparung
- 95: Stützfläche
- 96: Stützbereich
- 97: Freiraum

- 100: Kühlkanal
- 101: Kanalwand
- 102: Heatpipe
- 103: Zwischenraum

- 105: explosionsgeschütztes Gehäuse
- 106: Gehäuseinnenraum
- 107: Montageplatte
- 108: Montagefläche
- 109: Gehäuseboden
- 110: Gehäusedecke
- 111: Gehäuserückwand
- 112: Montageplattenhalter
- 113: Wand
- 114: Montagestreben

- α: stumpfer Winkel

- H: Höhenrichtung
- K: Konvektionsströmung
- L: Längsrichtung
- Q: Querrichtung
- s: Abstand
- x: Kanalbreite
- z: Kanalhöhe

## Patentansprüche

1. Modulares System (20)
mit wenigstens einem Modul (21), das auf einem Bauelementträger (23) angeordnete elektrische und/oder elektronische Bauelemente (24) und einen Wärmeleitkörper (25) aufweist,
wobei das wenigstens eine Modul (21) eine mechanische Verbindungseinrichtung (34) aufweist,
wobei der Wärmeleitkörper (25) an einem Basisteil (26) eine Anlagefläche (45) aufweist, die an der Unterseite des Basisteils (26) angeordnet und wenigstens einem Modulträger (22) zugewandt ist,
wobei der wenigstens eine Modulträger (22) eine Halteeinrichtung (67) zur Herstellung einer mechanischen Verbindung mit wenigstens einer Verbindungseinrichtung (34) eines Moduls (21) aufweist,
wobei der wenigstens eine Modulträger (22) wenigstens eine Gegenanlagefläche (70) aufweist, an der die Anlagefläche (45) eines Moduls (21) anliegt, wenn zwischen der Halteeinrichtung (67) des Modulträgers (22) und der Verbindungseinrichtung (34) des Moduls (21) eine Verbindung hergestellt ist, wodurch eine Wärmeleitverbindung zwischen dem Wärmeleitkörper (25) und dem Modulträger (22) hergestellt ist,
**dadurch gekennzeichnet, dass** das wenigstens eine Modul (21) eine elektrische Kopplungseinrichtung (55) mit elektrischen Kontakten aufweist, die elektrisch mit dem Bauelementträger (23) und/oder wenigstens einem der Bauelemente (24) verbunden ist, wobei die elektrischen Kontakte der Kopplungseinrichtung (55) durch eine Durchbrechung (58) im Basisteil (26) von der Unterseite des Basisteils (26) zugänglich sind,
und dass der Modulträger (22) eine Anschlusseinrichtung (80) mit komplementär zu den elektrischen Kontakten der Kopplungseinrichtung (55) ausgebildeten elektrischen Gegenkontakten zur Herstellung einer elektrischen Verbindung mit wenigstens einer Kopplungseinrichtung (55) eines Moduls (21) aufweist.

2. Modulares System nach Anspruch 1,
**dadurch gekennzeichnet, dass** der Wärmeleitkörper (25) einen Plattenteil (27) aufweist, der sich quer zur Anlagefläche (45) erstreckt.

3. Modulares System nach Anspruch 2,
**dadurch gekennzeichnet, dass** sich der Bauelementträger (23) eines Moduls (21) im Wesentlichen parallel zur dem Plattenteil (27) erstreckt.

4. Modulares System nach Anspruch 2 oder 3,
**dadurch gekennzeichnet, dass** die zu kühlenden elektrischen und/oder elektronischen Bauelemente (24) auf derselben Seite des Bauelementträgers (23) angeordnet sind und mit ihrer dem Bauelementträger (23) abgewandten Oberseite an dem Plattenteil (27) anliegen.

5. Modulares System nach Anspruch 4,
**dadurch gekennzeichnet, dass** der Plattenteil (27) auf seiner den zu kühlenden elektrischen und/oder elektronischen Bauelementen (24) zugewandten Seite Erhöhungen (31) und/oder Vertiefungen aufweist, um unterschiedliche Bauhöhen der Bauelemente (24) auszugleichen.

6. Modulares System nach einem der vorhergehenden Ansprüche,
**dadurch gekennzeichnet, dass** der Wärmeleitkörper (25) integral ohne Naht- und Fügestelle ausgeführt ist.

7. Modulares System nach einem der vorhergehenden Ansprüche,
**dadurch gekennzeichnet, dass** die Halteeinrichtung (67) einen Halteteil (68) aufweist, der eine Schwenkachse (S) definiert und dass die Verbindungseinrichtung (34) einen Verbindungsteil (35) aufweist, der dazu eingerichtet ist, an dem Halteteil (68) anzugreifen und eine Schwenkbewegung des Moduls (21) um die Schwenkachse (S) zu ermöglichen.

8. Modulares System nach Anspruch 7,
**dadurch gekennzeichnet, dass** die Schwenkachse (S) parallel zu der Gegenkontaktfläche (70) ausgerichtet ist.

9. Modulares System nach Anspruch 7 oder 8,
**dadurch gekennzeichnet, dass** der Verbindungsteil (35) eine Aufnahmeaussparung (37) aufweist, die dazu eingerichtet ist, den Halteteil (68) zumindest teilweise aufzunehmen.

10. Modulares System nach Anspruch 9,
**dadurch gekennzeichnet, dass** die Aufnahmeaussparung (37) in Richtung parallel zu der Schwenkachse (S) offen ist.

11. Modulares System nach einem der Ansprüche 7 bis 10,
**dadurch gekennzeichnet, dass** die Halteeinrichtung (67) mit Abstand zum Halteteil (68) einen Anbringungsteil (69) aufweist und dass die Verbindungseinrichtung mit Abstand zum Verbindungsteil (35) einen Befestigungsteil (36) aufweist, wobei der Befestigungsteil (36) und der Anbringungsteil (69) dazu eingerichtet sind kraftschlüssig und/oder formschlüssig miteinander verbunden zu werden.

12. Modulares System nach Anspruch 11 und nach Anspruch 2,
**dadurch gekennzeichnet, dass** die Anschlusseinrichtung (80) zwischen dem Halteteil (68) und dem Anbringungsteil (69) angeordnet ist und/oder dass die Kopplungseinrichtung (55) zwischen dem Verbindungsteil (35) und dem Befestigungsteil (36) angeordnet ist.

13. Modulares System nach einem der Ansprüche 7 bis 12,
**dadurch gekennzeichnet, dass** die Verbindungseinrichtung (34) eine Positionierfläche (48) aufweist, die mit Abstand zum Verbindungsteil (35) angeordnet ist und die dem Verbindungsteil (35) abgewandt ist, und dass die Halteeinrichtung (67) eine Positioniergegenfläche (77) aufweist, die mit Abstand zum Halteteil (68) angeordnet ist und die dem Halteteil (68) zugewandt ist, wobei die Positionierfläche (45) und die Positioniergegenfläche (77) bei hergestellter Verbindung zwischen der Halteeinrichtung (67) und der Verbindungseinrichtung (34) aneinander anliegen.

14. Modulares System nach einem der vorhergehenden Ansprüche,
**dadurch gekennzeichnet, dass** die Halteeinrichtung (67) und/oder die Verbindungseinrichtung (34) eine Krafterzeugungseinrichtung (87) aufweist, die bei hergestellter Verbindung zwischen der Halteeinrichtung (67) und der Verbindungseinrichtung (34) eine Andrückkraft zwischen der Anlagefläche (45) und der Gegenanlagefläche (70) erzeugt.

15. Modulares System nach Anspruch 13 und 14,
**dadurch gekennzeichnet, dass** die Krafterzeugungseinrichtung (87) bei hergestellter Verbindung zwischen der Halteeinrichtung (67) und der Verbindungseinrichtung (34) eine Andrückkraft zwischen der Positionierfläche (48) und der Positioniergegenfläche (77) erzeugt.

16. Modulares System nach Anspruch 14 oder 15 und nach einem der Ansprüche 7 bis 13,
**dadurch gekennzeichnet, dass** die Krafterzeugungseinrichtung (87) ein elastisches oder federelastisches Krafterzeugungselement (88) aufweist, das sich bei hergestellter Verbindung zwischen der Halteeinrichtung (67) und der Verbindungseinrichtung (34) am Halteteil (68) und am Verbindungsteil (35) abstützt.

17. Modulares System nach einem der vorhergehenden Ansprüche,
**dadurch gekennzeichnet, dass** der Modulträger (22) einen Modulkörper (66) aufweist, der als integraler Körper ohne Naht- und Fügestelle ausgeführt ist.

18. Gehäuse (105) mit einem modularen System nach einem der vorhergehenden Ansprüche,
wobei das Gehäuse (105) einen relativ zur Umgebung durch Gehäusewände gekapselten, Gehäuseinnenraum (106) aufweist,
wobei im Gehäuseinnenraum (106) eine Montageplatte (107) angeordnet ist, an der der wenigstens eine Modulträger (22) des modularen Systems für das wenigstens eine Modul (21) mit zu kühlenden elektrischen und/oder elektronischen Bauelementen (24) des modularen Systems angeordnet ist, wobei der wenigstens eine Modulträger (22) mit wenigstens einer Montagefläche (108) an der Montageplatte (107) unter Bildung einer wärmeleitenden Verbindung anliegt,
wobei der Gehäuseinnenraum (105) frei ist von aktiven Bauteilen, die eine Kühlungsströmung erzeugen,
und wobei sich durch die Erwärmung der Montageplatte (107) eine Wärmespreizung und damit eine Konvektionsströmung (K) im Gehäuseinnenraum (106) ausbildet.

## Claims

1. Modular system (20)
with at least one module (21) which comprises electrical and/or electronic components (24) arranged on a component carrier (23), and a heat-conducting body (25),
wherein the at least one module (21) has a mechanical connecting device (34),
wherein on a base part (26), the heat-conducting body (25) comprises a support face (45) which is arranged on the underside of the base part (26) and faces at least one module carrier (22),
wherein the at least one module carrier (22) has a holding device (67) for creating a mechanical connection with at least one connecting device (34) of a module (21),
wherein the at least one module carrier (22) has at least one counter support face (70) on which the support face (45) of a module (21) rests when a connection is created between the holding device (67) of the module carrier (22) and the connecting device (34) of the module (21), whereby a heat-conductive connection is created between the heat-conducting body (25) and the module carrier (22),
**characterised in that** the at least one module (21) has an electrical coupling device (55) with electrical contacts, which is electrically connected to the component carrier (23) and/or to at least one of the components (24), wherein the electrical contacts of the coupling device (55) are accessible through an opening (58) in the base part (26) from the underside of the base part (26),
and that the module carrier (22) has a joining device (80) with electrical countercontacts which are configured to be complementary to the electrical contacts of the coupling device (55), in order to create an electrical connection with at least one coupling device (55) of a module (21).

2. Modular system according to claim 1, **characterised in that** the heat-conducting body (25) has a plate part (27) which extends transversely to the support face (45).

3. Modular system according to claim 2, **characterised in that** the component carrier (23) of a module (21) extends substantially parallel to the plate part (27).

4. Modular system according to claim 2 or 3, **characterised in that** the electrical and/or electronic components (24) to be cooled are arranged on the same side of the component carrier (23) and rest on the plate part (27) with their top side facing away from the component carrier (23).

5. Modular system according to claim 4, **characterised in that** the plate part (27) has protrusions (31) and/or depressions on its side facing the electrical and/or electronic components (24) to be cooled, in order to compensate for different installation heights of the components (24).

6. Modular system according to any of the preceding claims, **characterised in that** heat-conducting body (25) is designed integrally without seams or joints.

7. Modular system according to any of the preceding claims, **characterised in that** the holding device (67) has a holding part (68) which defines a pivot axis (S), and that the connecting device (34) has a connecting part (35) which is configured to grip on the holding part (68) and allow a pivot movement of the module (21) about the pivot axis (S).

8. Modular system according to claim 7, **characterised in that** the pivot axis (S) is oriented parallel to the counter-contact face (70).

9. Modular system according to claim 7 or 8, **characterised in that** the connecting part (35) has a receiving recess (37) which is configured to at least partially receive the holding part (68).

10. Modular system according to claim 9, **characterised in that** the receiving recess (37) is open in the direction parallel to the pivot axis (S).

11. Modular system according to any of claims 7 to 10, **characterised in that** the holding device (67) has an attachment part (69) spaced from the holding part (68), and that the connecting device has a fixing part (36) spaced from the connecting part (35), wherein the fixing part (36) and the attachment part (69) are configured to be connected together by force fit and/or form fit.

12. Modular system according to claim 11 and claim 2, **characterised in that** the joining device (80) is arranged between the holding part (68) and the attachment part (69), and/or that the coupling device (55) is arranged between the connecting part (35) and the fixing part (36).

13. Modular system according to any of claims 7 to 12, **characterised in that** the connecting device (34) has a positioning face (48) which is arranged spaced apart from the connecting part (35) and faces away from the connecting part (35), and that the holding device (67) has a counter-positioning face (77) which is arranged spaced apart from the holding part (68) and faces the holding part (68), wherein the positioning face (45) and the counter-positioning face (77) bear against each other when a connection is created between the holding device (67) and the connecting device (34).

14. Modular system according to any of the preceding claims, **characterised in that** the holding device (67) and/or the connecting device (34) has a force-generating device (87) which creates a contact pressure force between the support face (45) and the counter-support face (70) when a connection is created between the holding device (67) and the connecting device (34).

15. Modular system according to claim 13 and 14, **characterised in that** the force-generating device (87) creates a contact pressure between the positioning face (48) and the counter-positioning face (77) when a connection is created between the holding device (67) and the connecting device (34).

16. Modular system according to claim 14 or 15 or any of claims 7 to 13, **characterised in that** the force-generating device (87) has an elastic or spring elastic force-generating element (88) which rests on the holding part (68) and on the connecting part (35) when a connection is created between the holding device (67) and the connecting device (34).

17. Modular system according to any of the preceding claims, **characterised in that** the module carrier (22) has a module body (66) which is configured as an integral body without seams or joints.

18. Housing (105) with a modular system according to any of the preceding claims,
wherein the housing (105) has a housing interior (106) which is encapsulated relative to the environment by housing walls,
wherein a mounting plate (107) is arranged in the housing interior (106), on which is arranged the at least one module carrier (22) of the modular system for the at least one module (21) with electrical and/or electronic components (24) of the modular system to be cooled, wherein at least one mounting face (108) of the at least one module carrier (22) bears on the mounting plate (107) to form a heat-conductive connection, wherein the housing interior (105) is free from active components which generate a cooling flow,
and wherein a heat spread and hence a convection flow (K) is formed in the housing interior (106) by the heating of the mounting plate (107).

## Revendications

1. Système modulaire (20),
comprenant au moins un module (21) qui présente des composants (24) électriques et/ou électroniques, disposés sur un support de composants (23), et un corps conducteur de chaleur (25),
dans lequel le module (21), au nombre d'au moins un, présente un dispositif de liaison (34) mécanique,
dans lequel le corps conducteur de chaleur (25) présente, sur un élément de base (26), une surface d'appui (45) qui est disposée sur la face inférieure de l'élément de base (26) et est tournée vers au moins un support de module (22),
dans lequel le support de module (22), au nombre d'au moins un, présente un dispositif de maintien (67) destiné à établir une liaison mécanique avec au moins un dispositif de liaison (34) d'un module (21),
dans lequel le support de module (22), au nombre d'au moins un, présente au moins une surface d'appui antagoniste (70) contre laquelle est appliquée la surface d'appui (45) d'un module (21) lorsqu'une liaison est établie entre le dispositif de maintien (67) du support de module (22) et le dispositif de liaison (34) du module (21), ce qui a pour effet de réaliser une liaison thermoconductrice entre le corps conducteur de chaleur (25) et le support de module (22),
**caractérisé en ce que** le module, au nombre d'au moins un, présente un dispositif de couplage (55) électrique qui est doté de contacts électriques et est raccordé sur le plan électrique au support de composants (23) et/ou à au moins un des composants (24), les contacts électriques du dispositif de couplage (55) étant accessibles à travers une ouverture (58) dans l'élément de base (26), depuis la face inférieure de l'élément de base (26),
et **en ce que** le support de module (22) présente un dispositif de raccordement (80) doté de contacts électriques conjugués, réalisés de façon complémentaire aux contacts électriques du dispositif de couplage (55) et destinés à établir une liaison électrique avec au moins un dispositif de couplage (55) d'un module (21).

2. Système modulaire selon la revendication 1, **caractérisé en ce que** le corps conducteur de chaleur (25) présente un élément formant plaque (27) qui s'étend transversalement à la surface d'appui (45).

3. Système modulaire selon la revendication 2, **caractérisé en ce que** le support de composants (23) d'un module (21) s'étend sensiblement de façon parallèle à l'élément formant plaque (27).

4. Système modulaire selon la revendication 2 ou 3, **caractérisé en ce que** les composants (24) électriques et/ou électroniques à refroidir sont disposés sur la même face du support de composants (23) et sont appliqués contre l'élément formant plaque (27) avec leur face supérieure opposée au support de composants (23).

5. Système modulaire selon la revendication 4, **caractérisé en ce que** sur sa face tournée vers les composants (24) électriques et/ou électroniques à refroidir, l'élément formant plaque (27) présente des saillies (31) et/ou des creux destinés à compenser des hauteurs de construction différentes des composants (24).

6. Système modulaire selon l'une des revendications précédentes, **caractérisé en ce que** le corps conducteur de chaleur (25) est réalisé d'une seule pièce, sans point de jonction ni d'assemblage.

7. Système modulaire selon l'une des revendications précédentes, **caractérisé en ce que** le dispositif de maintien (67) présente un élément de maintien (68) qui définit un axe de pivotement (S), et **en ce que** le dispositif de liaison (34) présente un élément de liaison (35) qui est conçu pour venir en prise sur l'élément de maintien (68) et permettre un mouvement pivotant du module (21) autour de l'axe de pivotement (S).

8. Système modulaire selon la revendication 7, **caractérisé en ce que** l'axe de pivotement (S) est orienté parallèlement à la surface de contact antagoniste (70).

9. Système modulaire selon la revendication 7 ou 8, **caractérisé en ce que** l'élément de liaison (35) présente un évidement de réception (37) qui est agencé pour recevoir au moins en partie l'élément de maintien (68).

10. Système modulaire selon la revendication 9, **caractérisé en ce que** l'évidement de réception (37) est ouvert dans le sens qui est parallèle à l'axe de pivotement (S).

11. Système modulaire selon l'une des revendications 7 à 10, **caractérisé en ce que** le dispositif de maintien (67) présente un élément de montage (69) situé à distance de l'élément de maintien (68), et **en ce que** le dispositif de liaison présente un élément de fixation (36) situé à distance de l'élément de liaison (35), l'élément de fixation (36) et l'élément de montage (69) étant conçus pour être reliés l'un à l'autre par adhérence et/ou par forme.

12. Système modulaire selon la revendication 11 et selon la revendication 2, **caractérisé en ce que** le dispositif de raccordement (80) est placé entre l'élément de maintien (68) et l'élément de montage (69) et/ou **en ce que** le dispositif de couplage (55) est placé entre l'élément de liaison (35) et l'élément de fixation (36).

13. Système modulaire selon l'une des revendications 7 à 12, **caractérisé en ce que** le dispositif de liaison (34) présente une surface de positionnement (48) qui est placée à distance de l'élément de liaison (35) et qui est éloignée de l'élément de liaison (35), et **en ce que** le dispositif de maintien (67) présente une surface de positionnement antagoniste (77) qui est placée à distance de l'élément de maintien (68) et qui est tournée vers l'élément de maintien (68), la surface de positionnement (45) et la surface de positionnement antagoniste (77) étant appliquées l'une contre l'autre lorsque la liaison entre le dispositif de maintien (67) et le dispositif de liaison (34) est établie.

14. Système modulaire selon l'une des revendications précédentes, **caractérisé en ce que** le dispositif de maintien (67) et/ou le dispositif de liaison (34) présentent un dispositif de génération de force (87) qui produit une force de pression entre la surface d'appui (45) et la surface d'appui antagoniste (70), lorsque la liaison entre le dispositif de maintien (67) et le dispositif de liaison (34) est établie.

15. Système modulaire selon la revendication 13 et 14, **caractérisé en ce que** le dispositif de génération de force (87) produit une force de pression entre la surface de positionnement (48) et la surface de positionnement antagoniste (77), lorsque la liaison entre le dispositif de maintien (67) et le dispositif de liaison (34) est établie.

16. Système modulaire selon la revendication 14 ou 15 et selon l'une des revendications 7 à 13, **caractérisé en ce que** le dispositif de génération de force (87) présente un élément de génération de force (88) élastique ou souple élastique qui est en appui sur l'élément de maintien (68) et sur l'élément de liaison (35), lorsque la liaison entre le dispositif de maintien (67) et le dispositif de liaison (34) est établie.

17. Système modulaire selon l'une des revendications précédentes, **caractérisé en ce que** le support de module (22) présente un corps de module (66) qui est réalisé sous forme de corps monobloc, sans point de jonction ni d'assemblage.

18. Boîtier (105) comprenant un système modulaire selon l'une des revendications précédentes,
sachant que le boîtier (105) présente une cavité de boîtier (106) qui est encapsulée vis-à-vis de l'environnement par des parois de boîtier,
sachant qu'il est prévu dans la cavité de boîtier (106), une plaque de montage (107) sur laquelle est disposé le support de module (22), au nombre d'au moins un, du système modulaire, pour le module (21), au nombre d'au moins un, comportant des composants (24) électriques et/ou électroniques à refroidir, le support de module (22), au nombre d'au moins un, étant appliqué avec au moins une surface de montage (108) contre la plaque de montage (107), en établissant une liaison conductrice de chaleur,
sachant que la cavité de boîtier (105) est dépourvue de composants actifs qui génèrent un courant de refroidissement,
et sachant que l'échauffement de la plaque de montage (107) a pour effet la formation d'une diffusion de chaleur et par conséquent d'un courant de convection (K) dans la cavité de boîtier (106).
